# EUROPEAN PATENT APPLICATION

(11) **EP 4 823 298 A1**
(43) Date of publication of application: **14.10.2026**
(21) Application number: 24901176.8
(22) Date of filing: 11.10.2024
(51) Int. Cl.: H10K 59/131, G09G 3/00, G09G 3/3233, H10K 77/10, H10K 71/70, H10K 59/80, H10K 59/88

(54) **DISPLAY DEVICE AND MANUFACTURING METHOD THEREFOR**

(30) Priority: 05.12.2023 KR 20230174005
(71) Applicant: Samsung Display Co., Ltd., Yongin-si, Gyeonggi-do 17113 (KR)
(72) Inventor: KANG, Young Gu, Yongin-Si Gyeonggi-do 17113 (KR); PARK, Hyeon Do, Yongin-Si Gyeonggi-do 17113 (KR); JO, Sung Chan, Yongin-Si Gyeonggi-do 17113 (KR); PARK, Hyun Sung, Yongin-Si Gyeonggi-do 17113 (KR); SEO, Yu Deok, Yongin-Si Gyeonggi-do 17113 (KR)
(74) Representative: Marks & Clerk LLP
(86) International application number: PCT/KR2024/096319
(87) International publication number: WO 2025/121990

(57) **Abstract**

Provided is a display device and a method of manufacturing the same. The display device includes a display panel; and a circuit board bonded to the display panel. The display panel includes: a substrate; a circuit layer disposed on the substrate; and an element layer disposed on the circuit layer. The substrate includes a main region and a sub-region. The circuit layer includes light emitting pixel drivers arranged side by side with each other in a first direction and a second direction; first power lines extending in the second direction, and transmitting a first power to the light emitting pixel drivers; a power sensing line extending from a first side of an edge portion of the display area to the sub-region, and electrically connected to one first power line of the first power lines; and a power sensing extension line electrically connected to the power sensing line and in contact with a side of an edge portion of the sub-region.

## Description

### [Technical Field]

The present disclosure relates to a display device and a method of manufacturing the same.

### 2. Description of the Related Art

With the advancement of information-oriented society, there are increasing demands placed on display devices for displaying images in various ways. For example, display devices are implemented in various electronic devices such as smartphones, digital cameras, laptop computers, navigation devices, and smart televisions.

The display device may be a flat panel display device such as a liquid crystal display device, a field emission display device and a light emitting display device. Examples of the light emitting display device may include an organic light emitting display device including organic light emitting elements, an inorganic light emitting display device including inorganic light emitting elements such as inorganic semiconductors, and a micro light emitting display device including micro light emitting elements.

The organic light emitting display device displays an image using light emitting elements, and each of the light emitting elements includes a light emitting layer made of an organic light emitting material. As described above, the organic light emitting display device implements image display using a self-light emitting element, and thus may have relatively superior performance in power consumption, response speed, luminous efficiency, luminance, and wide viewing angle compared to other display devices.

A surface of the display device may include a display area in which an image is displayed and a non-display area that is a periphery of the display area. Emission areas for emitting light with respective luminances and colors may be arranged in the display area.

### [Disclosure]

### [Technical Problem]

A method of manufacturing a display device may include the step of inspecting whether light emitting elements disposed in emission areas of a display area are turned on normally.

In the step of performing a lighting inspection, static electricity may be introduced through pads connected to a connector of an inspection device. In this case, there is a problem in that a disconnection defect may readily occur as charges are concentrated in a portion with relatively high resistance among wires adjacent to the pads.

In addition, since the lifting defect of insulating layers including an inorganic insulating material occurs at the point at which the disconnection defect due to static electricity occurs, a permeation path for oxygen or moisture is generated, so that there is a problem in that the lifespan of the display device may be reduced.

In view of the above, aspects of the present disclosure provide a display device capable of reducing a disconnection defect due to static electricity introduced during lighting inspection and a method of manufacturing the display device.

It should be noted that objects of the disclosure are not limited to the above-described objects, and other objects of the disclosure will be apparent to those skilled in the art from the following descriptions.

### [Technical Solution]

According to an aspect of the present disclosure, a display device comprises a display panel; and a circuit board bonded to the display panel. The display panel comprises: a substrate; a circuit layer disposed on the substrate; and an element layer disposed on the circuit layer. The substrate comprises a main region and a sub-region protruding from a side of the main region. The main region comprises a display area in which emission areas are arranged, and a non-display area disposed around the display area. The element layer comprises light emitting elements respectively disposed in the emission areas. The circuit layer comprises light emitting pixel drivers arranged side by side with each other in a first direction and a second direction and electrically connected to the light emitting elements, respectively; first power lines disposed in the display area, extending in the second direction, and transmitting a first power to the light emitting pixel drivers; a power sensing line disposed in the non-display area, extending from a first side of an edge portion of the display area facing the sub-region and adjacent to the sub-region to the sub-region, and electrically connected to one first power line of the first power lines; and a power sensing extension line electrically connected to the power sensing line and in contact with a side of an edge portion of the sub-region.

The circuit layer may further include pads disposed in the sub-region and connected to the circuit board. The pads may include a power sensing transmission pad electrically connected to the power sensing line. The power sensing line may be connected to a side of the power sensing transmission pad. The power sensing extension line may extend from another side of the power sensing transmission pad to the side of the edge portion of the sub-region.

The circuit layer may further include a power sensing additional line disposed in the non-display area, extending from a second side of the edge portion of the display area, which is opposite the first side to the sub-region of the edge portion of the display area, and electrically connected to another first power line of the first power lines. The pads may further include a power sensing additional pad electrically connected to the power sensing additional line.

The display device may further include an encapsulation layer disposed on the element layer; and at least one dam portion disposed in a dam area of the non-display area surrounding the display area. The circuit layer may further include a first gate insulating layer disposed on the substrate; a first gate conductive layer disposed on the first gate insulating layer; a second gate insulating layer covering the first gate conductive layer; a second gate conductive layer disposed on the second gate insulating layer; a first interlayer insulating layer covering the second gate conductive layer; a third gate insulating layer disposed on the first interlayer insulating layer; a third gate conductive layer disposed on the third gate insulating layer; a second interlayer insulating layer covering the third gate conductive layer; a first source-drain conductive layer disposed on the second interlayer insulating layer; a first planarization layer covering the first source-drain conductive layer; a second source-drain conductive layer disposed on the first planarization layer; and a second planarization layer covering the second source-drain conductive layer. A bypass portion of the power sensing line overlapping the dam area may be disposed on one of the first gate conductive layer, the second gate conductive layer, and the third gate conductive layer. A first main portion of the power sensing line disposed between the bypass portion and the one first power line may be disposed on at least one of the first source-drain conductive layer or the second source-drain conductive layer. A second main portion of the power sensing line disposed between the bypass portion and the power sensing transmission pad is disposed on at least one of the first source-drain conductive layer or the second source-drain conductive layer.

The bypass portion may have a form comprising jig portions whose extension direction is variable.

A part of the first main portion of the power sensing line adjacent to the bypass portion may have a form comprising jig portions whose extension direction is variable.

A total extension length of the jig portions may correspond to a total length of the bypass portion.

The encapsulation layer may include: a first encapsulation layer disposed on the element layer; a second encapsulation layer disposed on the first encapsulation layer; and a third encapsulation layer disposed on the first encapsulation layer and covering the second encapsulation layer. Each of the first encapsulation layer and the third encapsulation layer may include an inorganic insulating material. The second encapsulation layer may include an organic insulating material disposed in an area surrounded by the at least one dam portion. The third encapsulation layer may be in contact with the first encapsulation layer at an outside of the dam area.

The substrate may further include an inspection pad area connected to a side of the edge portion of the sub-region. The circuit layer may further include: inspection connection pads disposed in the inspection pad area and connected to a connector of an inspection device that supplies inspection signals for lighting inspection; and inspection connection lines disposed in the inspection pad area and extending from the side of the edge portion of the sub-region. The inspection connection lines may include a power sensing dummy line connected to the power sensing extension line.

The inspection connection pads may include a dummy pad electrically connected to the power sensing dummy line.

The circuit layer may further include a first power supply line disposed in the non-display area and transmitting the first power; and a first power extension line electrically connected to the first power supply line and in contact with the side of the edge portion of the sub-region. The inspection connection lines may further include a first power connection line connected to the first power extension line. The inspection connection pads may further include a first power supply pad electrically connected to the first power connection line. The power sensing dummy line may be electrically connected to the first power connection line.

According to an aspect of the present disclosure, there is provided a method of manufacturing a display device, the method comprises preparing an inspection panel; performing a lighting inspection on the inspection panel by using an inspection device connected to inspection connection pads of an inspection pad area in the inspection panel; preparing a display panel by removing the inspection pad area in the inspection panel; and bonding a circuit board to pads of a sub-region in the display panel. In the preparing of the inspection panel, the display panel comprises: a substrate; a circuit layer disposed on the substrate; and an element layer disposed on the circuit layer. The substrate comprises a main region comprising a display area in which emission areas are arranged, and a non-display area disposed around the display area; and a sub-region protruding from a side of the main region and having a side connected to the inspection pad area. The element layer comprises light emitting elements respectively disposed in the emission areas. The circuit layer comprises light emitting pixel drivers arranged side by side with each other in a first direction and a second direction and electrically connected to the light emitting elements, respectively; first power lines disposed in the display area, extending in the second direction, and transmitting a first power to the light emitting pixel drivers; a power sensing line disposed in the non-display area, extending from a first side of an edge portion of the display area facing the sub-region and adjacent to the sub-region to the sub-region, and electrically connected to one first power line of the first power lines; a power sensing extension line electrically connected to the power sensing line and in contact with the side of an edge portion of the sub-region; inspection connection pads disposed in the inspection pad area; and inspection connection lines disposed in the inspection pad area and extending from the side of the edge portion of the sub-region. The inspection connection lines comprise a power sensing dummy line electrically connected to the power sensing extension line.

In the preparing of the inspection panel, the circuit layer may further include pads disposed in the sub-region and connected to the circuit board. The pads may include a power sensing transmission pad electrically connected to the power sensing line. The power sensing line may be connected to a side of the power sensing transmission pad. The power sensing extension line may extend from another side of the power sensing transmission pad to the side of the edge portion of the sub-region.

The inspection connection pads may include a dummy pad electrically connected to the power sensing dummy line.

In the preparing of the inspection panel, the circuit layer may further include a first power supply line disposed in the non-display area and transmitting the first power; and a first power extension line electrically connected to the first power supply line and in contact with a side of the edge portion of the sub-region. The inspection connection lines may further include a first power connection line connected to the first power extension line. The inspection connection pads may further include a first power supply pad electrically connected to the first power connection line.

The power sensing dummy line may be electrically connected to the first power connection line.

In the preparing of the inspection panel, the circuit layer may further include a power sensing additional line disposed in the non-display area, extending from a second side of the edge portion of the display area, which is opposite the first side of the edge portion of the display area, to the sub-region, and electrically connected to another first power line of the first power lines. The pads may further include a power sensing additional pad electrically connected to the power sensing additional line.

In the preparing of the inspection panel, the inspection panel may further include at least one dam portion disposed in a dam area of the non-display area surrounding the display area. The circuit layer may further include a first gate insulating layer disposed on the substrate; a first gate conductive layer disposed on the first gate insulating layer; a second gate insulating layer covering the first gate conductive layer; a second gate conductive layer disposed on the second gate insulating layer; a first interlayer insulating layer covering the second gate conductive layer; a third gate insulating layer disposed on the first interlayer insulating layer; a third gate conductive layer disposed on the third gate insulating layer; a second interlayer insulating layer covering the third gate conductive layer; a first source-drain conductive layer disposed on the second interlayer insulating layer; a first planarization layer covering the first source-drain conductive layer; a second source-drain conductive layer disposed on the first planarization layer; and a second planarization layer covering the second source-drain conductive layer. A bypass portion of the power sensing line overlapping the dam area may be disposed on one of the first gate conductive layer, the second gate conductive layer, and the third gate conductive layer. A first main portion of the power sensing line disposed between the bypass portion and the one first power line may be disposed on at least one of the first source-drain conductive layer or the second source-drain conductive layer. A second main portion of the power sensing line disposed between the bypass portion and the power sensing transmission pad may be disposed on at least one of the first source-drain conductive layer or the second source-drain conductive layer.

The bypass portion may have a form comprising jig portions whose extension direction is variable.

A part of the first main portion of the power sensing line adjacent to the bypass portion may have a form comprising jig portions whose extension direction is variable.

Specific details of other embodiments are included in the detailed description and drawings.

### [Advantageous Effects]

The display device according to embodiments may include a display panel and a circuit board. The display panel may include a substrate, a circuit layer, and an element layer. The circuit layer may include first power lines, a power sensing line that extends from a first side of a display area to a sub-region and is electrically connected to one first power line of the first power lines, and a power sensing extension line that is electrically connected to the power sensing line and in contact with a side of the edge portion of the sub-region.

In the step of preparing an inspection panel before the step of performing a lighting inspection, the circuit layer of the inspection panel may further include a power sensing dummy line that is disposed in an inspection pad area, extends from the side of the edge portion of the sub-region, and is connected to the power sensing extension line.

In this way, as the circuit layer includes the power sensing extension line and the power sensing dummy line, the static electricity introduced around a power sensing transmission pad may not only be introduced to the side of the power sensing line, but also disperse into the power sensing extension line and the power sensing dummy line.

Accordingly, bursting and disconnection defects in the power sensing line due to overheating of a portion of the power sensing line because of the concentration of static electricity may be reduced.

Accordingly, the generation of oxygen or moisture paths due to the bursting of the power sensing line may be prevented, and thus the lifespan of the display device may be improved.

However, effects according to the embodiments of the present disclosure are not limited to those exemplified above and various other effects are incorporated herein.

### [Description of Drawings]

FIGS. 1 and 2 are plan views showing a display device according to embodiments;
FIG. 3 is a cross-sectional view taken along line A-A' of FIG. 2;
FIG. 4 is a layout diagram illustrating a part B of FIG. 2;
FIG. 5 is an equivalent circuit of the light emitting pixel driver of FIG. 4;
FIG. 6 is a cross-sectional view illustrating a light emitting element, and the first transistor, the second transistor, the fourth transistor, and the sixth transistor of FIG. 5;
FIG. 7 is a layout diagram showing a part A of FIG. 1 according to embodiments;
FIG. 8 is a plan view showing a part D of FIG. 7 according to an embodiment;
FIG. 9 is a cross-sectional view taken along line E-E' of FIG. 8;
FIGS. 10, 11, and 12 are plan views illustrating a part D of FIG. 7 according to the respective embodiments;
FIG. 13 is a flowchart illustrating a method of manufacturing the display device according to embodiments;
FIG. 14 is a plan view illustrating the inspection panel during the step of preparing the inspection panel of FIG. 13 according to embodiments;
FIG. 15 is a layout diagram showing a part F of FIG. 14 according to an embodiment;
FIGS. 16 and 17 are process diagrams illustrating steps of performing the lighting inspection of FIG. 13 according to an embodiment;
FIG. 18 is a process diagram illustrating steps of performing the lighting inspection of FIG. 13 according to a comparative example; and
FIG. 19 is a layout diagram showing a part F of FIG. 14 according to another embodiment.

### [Best Mode]

The advantages and features of the present invention and methods for achieving them will become clear by referring to the embodiments described in detail below along with the accompanying drawings. However, the present invention is not limited to the embodiments disclosed below and will be implemented in various different forms. The present embodiments only serve to ensure that the disclosure of the present invention is complete and that common knowledge in the technical field to which the present invention pertains is not limited. It is provided to fully inform those who have the scope of the invention, and the present invention is only defined by the scope of the claims.

When an element or layer is referred to as "on" another element or layer, it includes instances where the element or layer is directly on top of or intervening with the other element. Like reference numerals refer to like elements throughout the specification. The shape, size, ratio, angle, number, etc. disclosed in the drawings for explaining the embodiments are illustrative and the present invention is not limited to the details shown.

Although first, second, etc. are used to describe various components, these components are of course not limited by these terms. These terms are merely used to distinguish one component from another. Therefore, it goes without saying that the first component mentioned below may also be a second component within the technical concept of the present invention.

Features of each of the various embodiments of the present invention may be partially or entirely coupled or combined with each other, various technical connections and operations are possible, and each of the embodiments may be independently implemented with respect to each other or may be implemented together in a related relationship.

Hereinafter, embodiments will be described in detail with reference to the accompanying drawings.

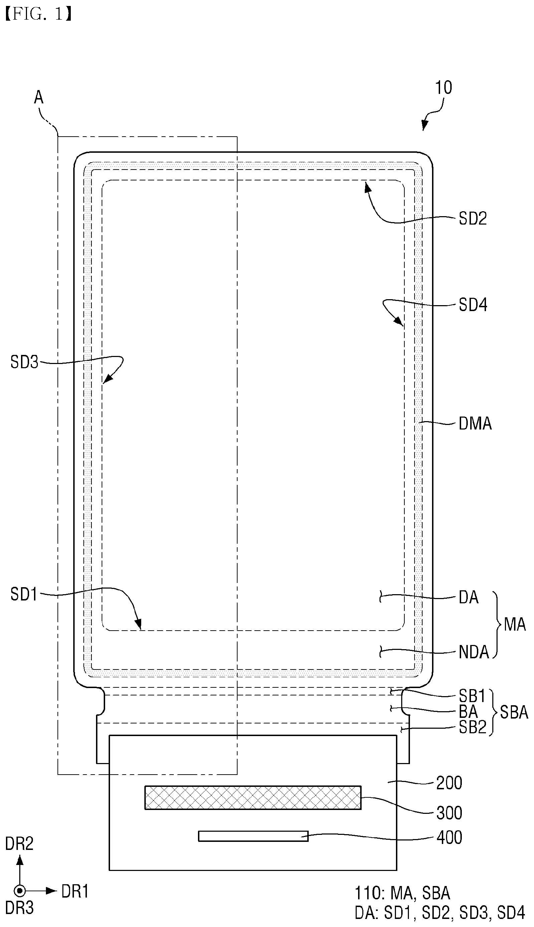

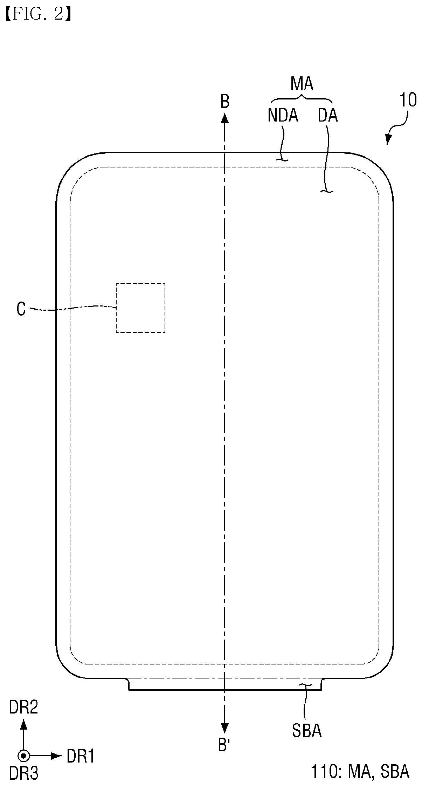

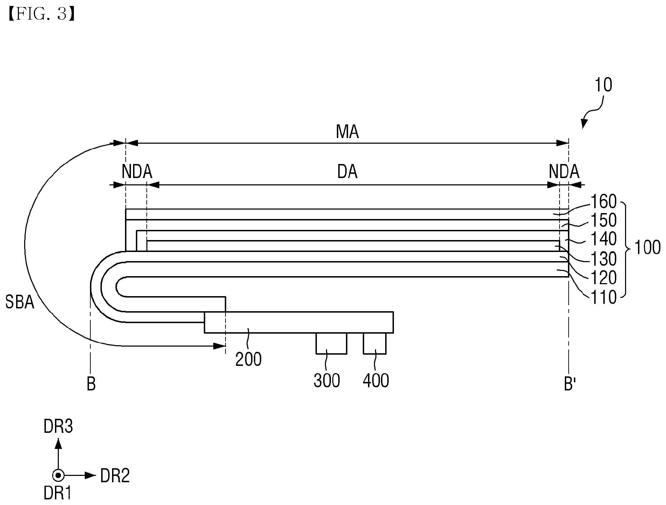

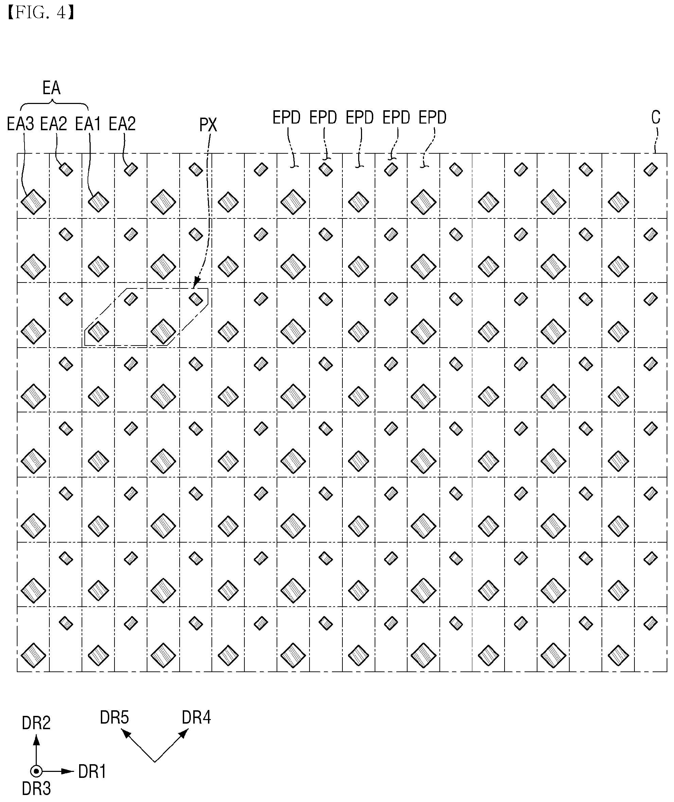

FIGS. 1 and 2 are plan views showing a display device according to embodiments. FIG. 3 is a cross-sectional view taken along line A-A' of FIG. 2. FIG. 4 is a layout diagram illustrating part B of FIG. 2.

Referring to FIGS. 1 and 2, a display device 10 may be a device for displaying a moving image or a still image. The display device 10 may be used as a display screen of various devices, such as a television, a laptop computer, a monitor, a billboard and an Internet-of-Things (IOT) device, as well as portable electronic devices such as a mobile phone, a smartphone, a tablet personal computer (PC), a smart watch, a watch phone, a mobile communication terminal, an electronic notebook, an electronic book, a portable multimedia player (PMP), a navigation device and an ultra-mobile PC (UMPC).

The display device 10 may be a light emitting display device such as an organic light emitting display using an organic light emitting diode, a quantum dot light emitting display including a quantum dot light emitting layer, an inorganic light emitting display including an inorganic semiconductor, and a micro light emitting display using a micro or nano light emitting diode (LED). Hereinafter, a case in which the display device 10 is an organic light emitting display device will be mainly described, but the present disclosure may be applied to a display device including an organic insulating material, an organic light emitting material, and a metal material.

The display device 10 may be formed to be flat, but embodiments are not limited thereto. For example, the display device 10 may include a curved portion formed at left and right end portions and having a constant curvature or a varying curvature. For example, the display device 10 may be formed flexibly so that the display device 10 may be bendable, foldable, or rollable.

The display device 10 may include a substrate 110, a display driving circuit 300, and a circuit board 200.

The substrate 110 may include a main region MA disposed on a surface (hereinafter, referred to as a display surface) where an image is displayed, and a sub-region SBA protruding from a side of the main region MA.

The main region MA may include a display area DA in which emission areas EA (see FIG. 4) emitting light with respective colors and luminances are arranged for displaying an image, and a non-display area NDA disposed around the display area DA.

The edge portions of the display area DA may include a first side SD1 and a second side SD2 that extend in a first direction DR1 and face each other, and a third side SD3 and a fourth side SD4 that extend in a second direction DR2, make connection between the first side SD1 and the second side SD2, and face each other.

For example, the first side SD1 and the second side SD2 may have a shorter length than the third side SD3 and the fourth side SD4. In this case, the display area DA may be provided in a plane of a quadrilateral shape.

As another example, the corner portions at which each of the first side SD1 and the second side SD2, and each of the third side SD3 and the fourth side SD4 meet may be rounded to have a selected curvature or right-angled.

As another example, the planar shape of the display area DA is not limited to the rectangular shape, and may be formed in another polygonal shape, a circular shape or an elliptical shape.

The non-display area NDA may be disposed at the edge portion of the main region MA and may be a shape surrounding the display area DA.

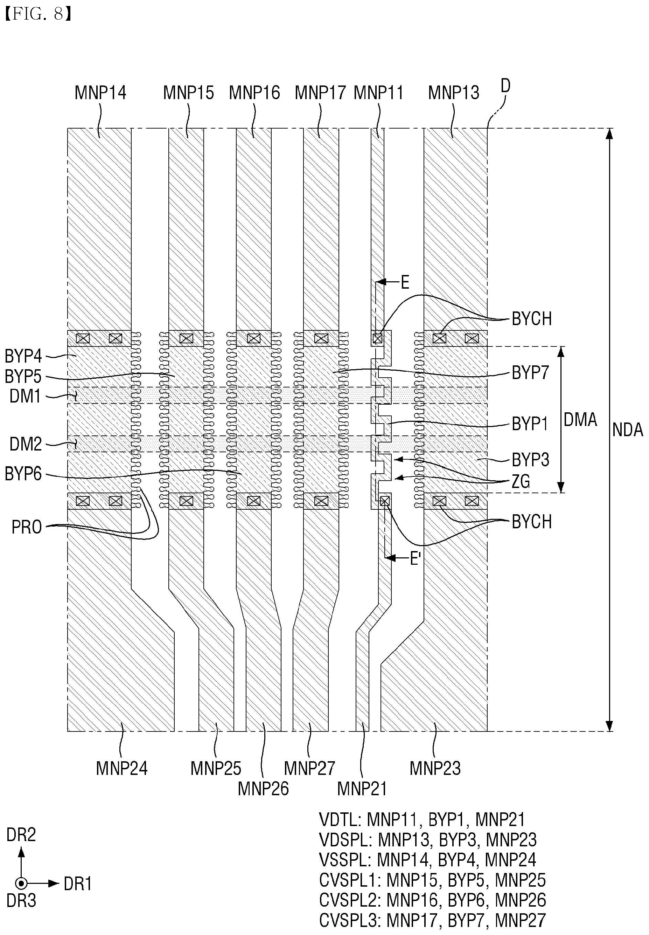

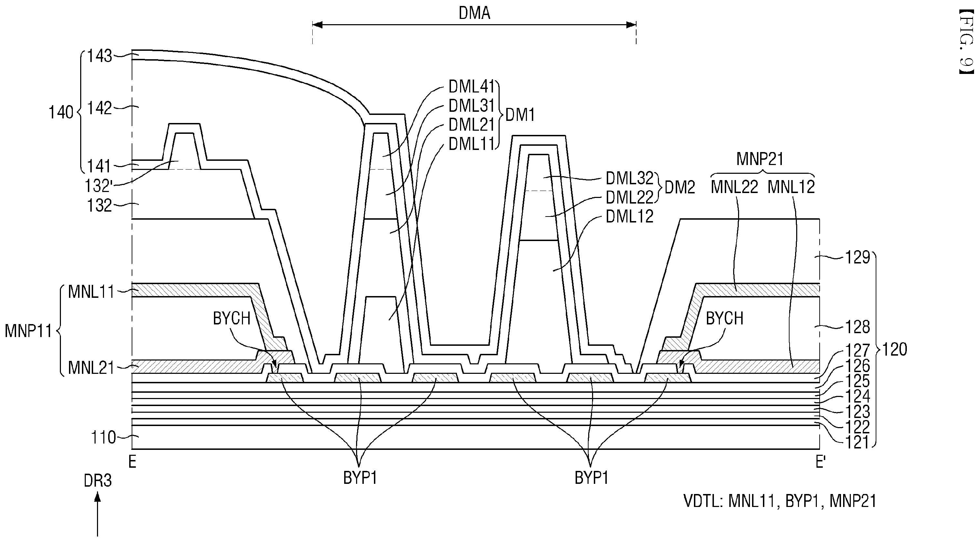

The non-display area NDA may include a dam area DMA that surrounds the display area DA and is spaced apart from the display area DA. At least one of a dam portion DM1 or DM2 (see FIGS. 8 and 9) having a ring shape surrounding the display area DA may be arranged in the dam area DMA.

The sub-region SBA may face to the first side SD1 of the display area DA and may be adjacent to the first side SD1 of the display area DA.

The sub-region SBA may include a bending area BA that is transformed into a bent shape, and a first sub-region SB1 and a second sub-region SB2 that are respectively in contact with both sides of the bending area BA.

The first sub-region SB1 may be disposed between the main region MA and the bending area BA. A side of the first sub-region SB1 may be in contact with the non-display area NDA of the main region MA, and another side of the first sub-region SB1 may be in contact with the bending area BA.

The second sub-region SB2 may be spaced apart from the main region MA with the first sub-region SB1 and the bending area BA therebetween.

In the case that the bending area BA is transformed into a bent shape, the second sub-region SB2 may be disposed on the bottom surface of the substrate 110. For example, the second sub-region SB2 may overlap the main region MA in a thickness direction (e.g., third direction DR3) of the substrate 110 due to the bending area BA transformed into a bent shape.

FIG. 1 illustrates a state in which the sub-region SBA is unfolded to be disposed side by side with the main region MA. On the other hand, FIGS. 2 and 3 illustrate a state in which the bending area BA of the sub-region SBA is bent.

Referring to FIG. 3, the display device 10 according to embodiments may include a display panel 100 through which light for displaying an image is emitted, and the circuit board 200 bonded to the display panel 100.

The display device 10 may further include the display driving circuit 300 mounted on the circuit board 200.

The display panel 100 may include the substrate 110, a circuit layer 120 disposed on the substrate 110, and an element layer 130 disposed on the circuit layer 120.

The display panel 100 may further include an encapsulation layer 140 disposed on the element layer 130, and a touch sensor layer 150 disposed on the encapsulation layer 140.

As illustrated in FIGS. 1 and 2, the substrate 110 may include the main region MA corresponding to the display surface and the sub-region SBA protruding from a side of the main region MA, and the main region MA may include the display area DA in which the emission areas EA (see FIG. 4) are arranged, and the non-display area NDA disposed around the display area DA.

The substrate 110 may be formed of an insulating material such as a polymer resin. For example, the substrate 110 may be formed of polyimide. The substrate 110 may be a flexible substrate which is bendable, foldable, or rollable.

In another example, the substrate 110 may be formed of an insulating material such as glass or the like.

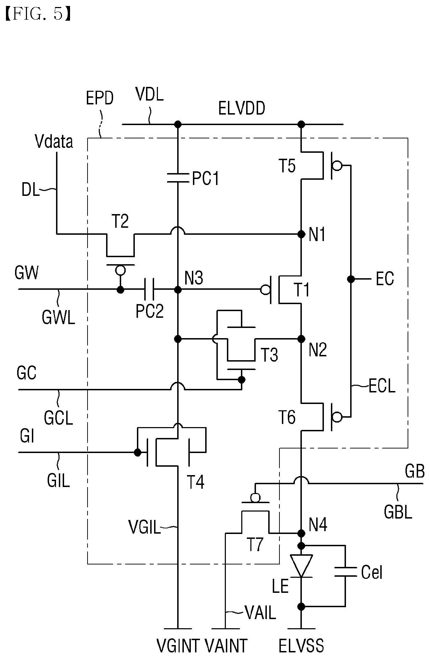

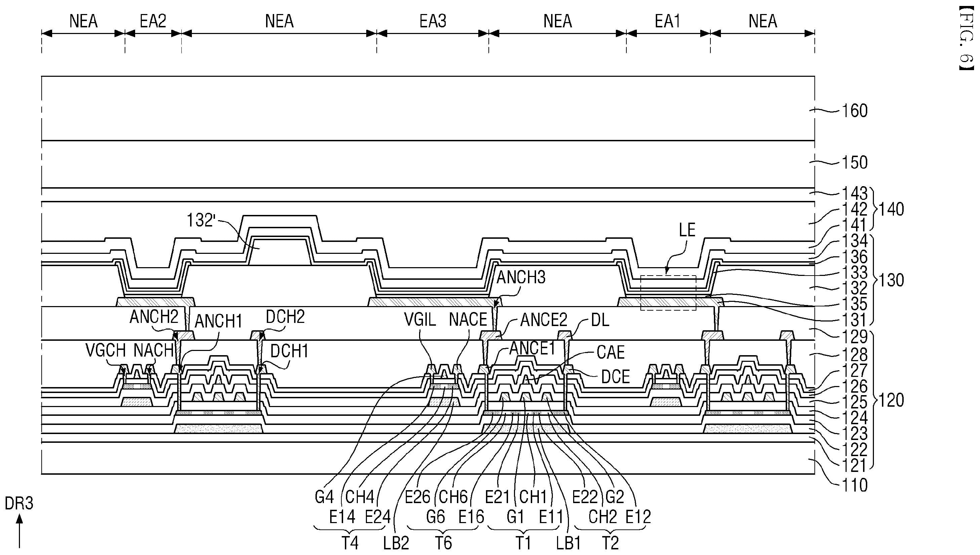

The element layer 130 may include light emitting elements LE (see FIGS. 5 and 6) respectively disposed in the emission areas EA.

The circuit layer 120 may include light emitting pixel drivers EPD (see FIGS. 4 and 5) electrically connected to the light emitting elements LE of the element layer 130, respectively.

The encapsulation layer 140 may be disposed on the element layer 130 and may have a structure in which two or more inorganic films and at least one organic film are alternately stacked with each other.

The touch sensor layer 150 may include touch electrodes for detecting a signal that varies according to the touch of a person or an object and sensing a point in the main region MA in which the touch of the person or the object has occurred.

A polarization layer 160 may block external light reflected from the touch sensor layer 150, the encapsulation layer 140, the element layer 130, and the circuit layer 120, and the interfaces thereof, and this is to prevent the deterioration of visibility of an image due to external light reflection.

The display device 10 may further include a cover window (not shown) disposed on the polarization layer 160. The cover window may be attached to the polarization layer 160 by a transparent adhesive member such as an optically clear adhesive (OCA) film or an optically clear resin (OCR). The cover window may be made of an inorganic material such as glass, or an organic material such as plastic or a polymer material. Due to the cover window, the touch sensor layer 150, the encapsulation layer 140, the element layer 130, and the circuit layer 120 may be protected from electrical and physical impact on the display surface.

The circuit board 200 may each be a flexible printed circuit board, a printed circuit board, or a flexible film such as a chip on film.

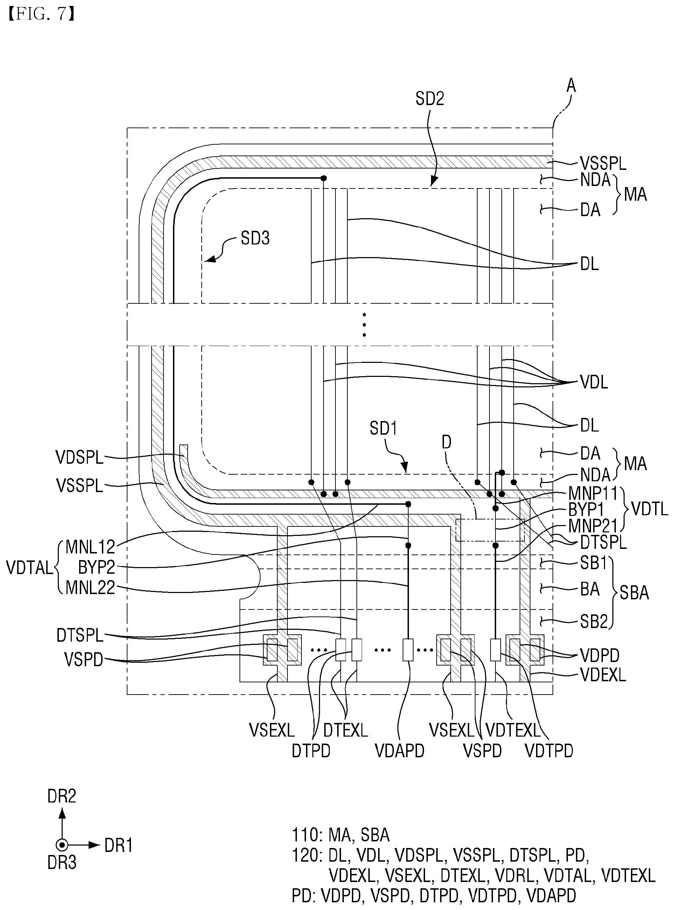

The circuit board 200 may be bonded to pads PD (see FIG. 7) disposed in the second sub-region SB2 of the substrate 110 by using a low-resistance, high-reliability material such as an anisotropic conductive film or super absorbent polymer (SAP).

The display driving circuit 300 may be provided as an integrated circuit chip (IC).

According to embodiments, the display driving circuit 300 may be attached to the circuit board 200 by using a chip on film (COF) method.

The display driving circuit 300 may output data signals to data lines DL (see FIG. 5) of the circuit layer 120.

The display device 10 may further include a touch driving circuit 400 for driving the touch sensor layer 150.

Referring to FIG. 4, the display area DA of the display device 10 may include the emission areas EA. For example, the display area DA may further include a non-emission area disposed in a gap between the emission areas EA.

The light emitting pixel drivers EPD that are respectively electrically connected to the light emitting elements LE of the emission areas EA may be arranged side by side in the main region MA in the first direction DR1 and the second direction DR2.

The light emitting pixel drivers EPD may be electrically connected to light emitting elements LE (see FIG. 5) of the element layer 130 respectively disposed in the emission areas EA.

The emission areas EA may have a rhombus shape or a rectangular shape in plan view. However, this is only an example, and the planar shape of the emission areas EA according to an embodiment is not limited to that illustrated in FIG. 4. For example, in plan view, the emission areas EA may have a polygonal shape such as a square, a pentagon, a hexagon, etc., or may have a circular or elliptical shape including the edge portion of a curve.

The emission areas EA may include first emission areas EA1 emitting light of a first color in a selected wavelength band, second emission areas EA2 emitting light of a second color in a wavelength band lower than that of the first color, and third emission areas EA3 emitting light of a third color in a wavelength band lower than that of the second color.

For example, the first color may be red having a wavelength band of about 600 nm to about 750 nm. The second color may be green having a wavelength band of about 480 nm to about 560 nm. The third color may be blue having a wavelength band of about 370 nm to about 460 nm.

The first emission areas EA1 and the third emission areas EA3 may be alternately arranged in at least one of the first direction DR1 or the second direction DR2.

The second emission areas EA2 may be arranged side by side in at least one of the first direction DR1 or the second direction DR2.

For example, the second emission areas EA2 may be adjacent to the first emission areas EA1 and the third emission areas EA3 in diagonal directions DR4 and DR5 intersecting the first direction DR1 and the second direction DR2.

Pixels PX displaying their own luminances and colors may be provided by the first emission area EA1, the second emission area EA2, and the third emission area EA3 adjacent to each other among these emission areas EA.

For example, the pixels PX may be a basic unit for displaying various colors including white with a selected luminance.

Each of the pixels PX may include at least one first emission area EA1, at least one second emission area EA2, and at least one third emission area EA3 that are adjacent to each other. Accordingly, each of the pixels PX may display various colors through a mixture of the light emitted from the first emission area EA1, the second emission area EA2, and the third emission area EA3 that are adjacent to each other.

FIG. 5 is an equivalent circuit diagram showing the light emitting pixel driver of FIG. 4.

Referring to FIG. 5, the light emitting pixel drivers EPD may be electrically connected to a first power ELVDD, and one the light emitting element LE of the light emitting elements LE of the element layer 130 may be electrically connected between one light emitting pixel driver EPD of the light emitting pixel drivers EPD of the circuit layer 120 and a second power ELVSS.

For example, the anode electrode of the light emitting element LE may be electrically connected to the light emitting pixel driver EPD, and the cathode electrode of the light emitting element LE may be applied with the second power ELVSS lower than the first power ELVDD.

A capacitor Cel connected in parallel with the light emitting element LE refers to a parasitic capacitance between the anode electrode and the cathode electrode.

The circuit layer 120 may further include a first power line VDL that transmits the first power ELVDD, a gate initialization voltage line VGIL that transmits a gate initialization voltage VGINT, and an anode initialization voltage line VAIL that transmits an anode initialization voltage VAINT.

The circuit layer 120 may further include a scan write line GWL for transmitting a scan write signal GW, a scan initialization line GIL for transmitting a scan initialization signal GI, an emission control line ECL for transmitting an emission control signal EC, a gate control line GCL for transmitting a gate control signal GC, and a bias control line GBL for transmitting a bias control signal GB.

The light emitting pixel driver EPD of the circuit layer 120 may include a first transistor T1 configured to generate a driving current for driving the light emitting element LE, two or more transistors T2 to T7 electrically connected to the first transistor T1, and at least one capacitor PC1.

The first transistor T1 may be electrically connected between a first node N1 and a second node N2. The first node N1 may be electrically connected to the first electrode (e.g., source electrode) of the first transistor T1. The second node N2 may be electrically connected to the second electrode (e.g., drain electrode) of the first transistor T1.

The first node N1 may be electrically connected to the first power line VDL through the fifth transistor T5.

The second node N2 may be electrically connected to the anode electrode of the light emitting element LE through the sixth transistor T6.

The first capacitor PC1 may be electrically connected between the first power line VDL and a third node N3. The third node N3 may be electrically connected to the gate electrode of the first transistor T1.

For example, the gate electrode of the first transistor T1 may be electrically connected to the first power line VDL through the first capacitor PC1.

Accordingly, the potential of the gate electrode of the first transistor T1 may be maintained at the voltage charged in the first capacitor PC1.

The second transistor T2 may be electrically connected between the data line DL and the first node N1.

The second transistor T2 may be electrically connected between the first electrode of the first transistor T1 and the data line DL.

For example, the first electrode of the first transistor T1 may be electrically connected to the data line DL through the second transistor T2.

The second transistor T2 may be turned on by the scan write signal GW of the scan write line GWL.

The fifth transistor T5 may be electrically connected between the first node N1 and the first power line VDL.

The sixth transistor T6 may be electrically connected between the second node N2 and a fourth node N4. The fourth node N4 may be electrically connected to the anode electrode of the light emitting element LE.

For example, the fifth transistor T5 may be electrically connected between the first electrode of the first transistor T1 and the first power line VDL.

The sixth transistor T6 may be electrically connected between the second electrode of the first transistor T1 and the anode electrode of the light emitting element LE.

The fifth transistor T5 and the sixth transistor T6 may be turned on by the emission control signal EC of the emission control line ECL.

In the case that a data signal Vdata of the data line DL is transmitted to the first electrode of the first transistor T1 through the turned-on second transistor T2, the voltage difference between the gate electrode of the first transistor T1 and the first electrode of the first transistor T1 may be a difference voltage between the first power ELVDD and the data signal Vdata.

For example, in the case that the voltage difference between the gate electrode of the first transistor T1 and the first electrode of the first transistor T1, e.g., the gate-to-source voltage difference becomes equal to or greater than a threshold voltage, the first transistor T1 may be turned on, thereby generating a drain-source current of the first transistor T1 corresponding to the data signal Vdata.

Subsequently, in the case that the fifth transistor T5 and the sixth transistor T6 are turned on, the first power ELVDD, the first transistor T1, the light emitting element LE, and the second power ELVSS may be connected in series. Accordingly, the drain-source current of the first transistor T1 corresponding to the data signal Vdata may be supplied as a driving current of the light emitting element LE.

Accordingly, the light emitting element LE may emit light having a luminance corresponding to the data signal Vdata.

The third transistor T3 may be electrically connected between the second node N2 and the third node N3. For example, the third transistor T3 may be electrically connected between the gate electrode of the first transistor T1 and the second electrode of the first transistor T1.

The third transistor T3 may be turned on by the gate control signal GC of the gate control line GCL.

Through the turned-on third transistor T3, the voltage difference between the second node N2 and the third node N3 may be initialized.

The fourth transistor T4 may be electrically connected between the gate initialization voltage line VGIL and the third node N3. For example, the fourth transistor T4 may be connected between the gate electrode of the first transistor T1 and the gate initialization voltage line VGIL.

The fourth transistor T4 may be turned on by the scan initialization signal GI of the scan initialization line GIL.

The potential of the third node N3 may be initialized through the turned-on fourth transistor T4.

The third transistor T3 and the fourth transistor T4 may be provided as N-type MOSFETs.

The seventh transistor T7 may be electrically connected between the fourth node N4 and the anode initialization voltage line VAIL. For example, the seventh transistor T7 may be electrically connected between the anode electrode of the light emitting element LE and the anode initialization voltage line VAIL.

The seventh transistor T7 may be turned on by the bias control signal GB of the bias control line GBL.

The potential of the fourth node N4 may be initialized through the turned-on seventh transistor T7.

According to embodiments, among the first to seventh transistors T1 to T7, the third transistor T3 and the fourth transistor T4 may be provided as N-type MOSFETs, and the other transistors T1, T2, and T5 to T7 except the third transistor T3 and the fourth transistor T4 may be provided as P-type MOSFETs.

According to embodiments, the circuit layer 120 may include a first semiconductor layer for providing a P-type MOSFET and a second semiconductor layer for providing an N-type MOSFET.

FIG. 6 is a cross-sectional view illustrating a light emitting element, and the first transistor, the second transistor, the fourth transistor, and the sixth transistor of FIG. 5.

Referring to FIG. 6, the display panel 100 of the display device 10 according to embodiments may include the substrate 110, the circuit layer 120 on the substrate 110, and the element layer 130 on the circuit layer 120.

The display panel 100 of the display device 10 according to embodiments may further include the encapsulation layer 140 on the element layer 130, the touch sensor layer 150 on the encapsulation layer 140, and the polarization layer 160 on the touch sensor layer 150.

The circuit layer 120 may include a first semiconductor layer CH1, E11, E21, CH2, E12, E22, CH6, E16, and E26 disposed on the substrate 110, a first gate insulating layer 123 covering the first semiconductor layer, a first gate conductive layer G1, G2, and G6 disposed on the first gate insulating layer 123, a second gate insulating layer 124 covering the first gate conductive layer, a second gate conductive layer CAE and LB2 disposed on the second gate insulating layer 124, a first interlayer insulating layer 125 covering the second gate conductive layer, a second semiconductor layer CH4, E14, and E24 disposed on the first interlayer insulating layer 125, a third gate insulating layer 126 covering the second semiconductor layer, a third gate conductive layer G4 disposed on the third gate insulating layer 126, a second interlayer insulating layer 127 covering the third gate conductive layer, a first source-drain conductive layer ANCE1, VGIL, and DCE disposed on the second interlayer insulating layer 127, a first planarization layer 128 covering the first source-drain conductive layer, a second source-drain conductive layer DL and ANCE2 disposed on the first planarization layer 128, and a second planarization layer 129 covering the second source-drain conductive layer.

According to embodiments, the circuit layer 120 may further include a barrier layer 121 disposed on the substrate 110, a first light blocking layer LB1 disposed on the barrier layer 121, and a buffer layer 122 covering the first light blocking layer LB1. For example, the first semiconductor layer CH1, E11, E21, CH2, E12, E22, CH6, E16, and E26 may be disposed on the buffer layer 122.

The circuit layer 120 may include the light emitting pixel drivers EPD respectively corresponding to the emission areas EA.

Each of the light emitting pixel drivers EPD may include the first transistor T1, the second to seventh transistors T2 to T7 (see FIG. 5) electrically connected to the first transistor T1, and at least one capacitor PC1 (see FIG. 5).

FIG. 6 shows the first transistor T1, the second transistor T2, the fourth transistor T4, and the sixth transistor T6 among the transistors T1 to T7 (see FIG. 5) of the light emitting pixel driver EPD.

The barrier layer 121 and the buffer layer 122 may include different inorganic insulating materials.

The first semiconductor layer on the buffer layer 122 may include the channel portions CH1, CH2, and CH6, the first electrode portions E11, E12, and E16, and the second electrode portions E21, E22, and E26 of the first transistor T1, the second transistor T2, the fifth transistor T5 (see FIG. 5), the sixth transistor T6, and the seventh transistor T7 that are provided as P-type MOSFETs.

The first gate conductive layer on the first gate insulating layer 123 may include the first gate electrodes G1, G2, and G6 of the first transistor T1, the second transistor T2, the fifth transistor T5 (see FIG. 5), the sixth transistor T6, and the seventh transistor T7 that are provided as P-type MOSFETs.

Since the fifth transistor T5 and the seventh transistor T7 have the same structure as those of the first transistor T1, the second transistor T2, and the sixth transistor T6, the redundant description will be omitted below.

In each of the first transistor T1, the second transistor T2, and the sixth transistor T6, the channel portions CH1, CH2, and CH6 may overlap the gate electrodes G1, G2, and G6.

The channel portion CH1 of the first transistor T1 may overlap the first light blocking layer LB1 below the buffer layer 122.

In each of the first transistor T1, the second transistor T2, and the sixth transistor T6, the first electrode portions E11, E12, and E16 may be connected to end portions of the channel portions CH1, CH2, and CH6, and the second electrode portions E21, E22, and E26 may be connected to the other end portions of the channel portions CH1, CH2, and CH6.

The first electrode portion E11 of the first transistor T1 may be connected to the second electrode portion E22 of the second transistor T2.

The second electrode portion E21 of the first transistor T1 may be connected to the first electrode portion E16 of the sixth transistor T6.

The second gate conductive layer on the second gate insulating layer 124 may include a capacitor electrode CAE and a second light blocking layer LB2.

The capacitor electrode CAE may overlap the gate electrode G1 of the first transistor T1.

Accordingly, the first capacitor PC1 (see FIG. 5) may be provided by the overlapping area between the capacitor electrode CAE and the gate electrode G1 of the first transistor T1.

The second semiconductor layer on the first interlayer insulating layer 125 may include the channel portion CH4, the first electrode portion E14, and the second electrode portion E24 of each of the third transistor T3 (see FIG. 5) and the fourth transistor T4 that are provided as N-type MOSFETs.

The third gate conductive layer G4 on the third gate insulating layer 126 may include the gate electrode G4 of each of the third transistor T3 (see FIG. 5) and the fourth transistor T4 that are provided as N-type MOSFETs.

In each of the third transistor T3 (see FIG. 5) and the fourth transistor T4, the channel portion CH4 may overlap the second light blocking layer LB2 below the first interlayer insulating layer 125.

The channel portion CH4 of the fourth transistor T4 may overlap the gate electrode G4 of the fourth transistor T4.

The first electrode portion E14 of the fourth transistor T4 may be connected to an end portion of the channel portion CH4 of the fourth transistor T4, and the second electrode portion E24 of the fourth transistor T4 may be connected to the other end portion of the channel portion CH4 of the fourth transistor T4.

Since the third transistor T3 has the same structure as that of the fourth transistor T4, the redundant description will be omitted below.

The first source-drain conductive layer on the second interlayer insulating layer 127 may include a first anode connection electrode ANCE1, a data connection electrode DCE, the gate initialization voltage line VGIL, and a node auxiliary connection electrode NACE.

The second source-drain conductive layer on the first planarization layer 128 may include a second anode connection electrode ANCE2 and the data line DL.

The data connection electrode DCE may be electrically connected to the first electrode portion E12 of the second transistor T2 through a first data connection hole DCH1.

The data line DL may be electrically connected to the data connection electrode DCE through a second data connection hole DCH2.

Accordingly, the data line DL may be electrically connected to the first electrode portion E12 of the second transistor T2 through the data connection electrode DCE.

An anode electrode 131 of the element layer 130 may be disposed on the second planarization layer 129.

The first anode connection electrode ANCE1 may be electrically connected to the second electrode portion E26 of the sixth transistor T6 through a first anode connection hole ANCH1.

The second anode connection electrode ANCE2 may be electrically connected to the first anode connection electrode ANCE1 through a second anode connection hole ANCH2.

The anode electrode 131 may be electrically connected to the second anode connection electrode ANCE2 through a third anode connection hole ANCH3.

Accordingly, the anode electrode 131 may be electrically connected to the second electrode portion E26 of the sixth transistor T6 through the first anode connection electrode ANCE1 and the second anode connection electrode ANCE2.

Each of the first data connection hole DCH1 and the first anode connection hole ANCH1 may penetrate the second interlayer insulating layer 127, the third gate insulating layer 126, the first interlayer insulating layer 125, the second gate insulating layer 124, and the first gate insulating layer 123.

Each of the second anode connection hole ANCH2 and the second data connection hole DCH2 may penetrate the first planarization layer 128.

The gate initialization voltage line VGIL may be electrically connected to the first electrode portion E14 of the fourth transistor T4 through a gate initialization voltage connection hole VGCH.

The node auxiliary connection electrode NACE may be electrically connected to the second electrode portion E24 of the fourth transistor T4 through the node auxiliary connection hole NACH.

Each of the gate initialization voltage connection hole VGCH and the node auxiliary connection hole NACH may penetrate the second interlayer insulating layer 127 and the third gate insulating layer 126.

The element layer 130 on the circuit layer 120 may include the light emitting elements LE respectively disposed in the emission areas EA1, EA2, and EA3.

Each of the light emitting elements LE may include a structure in which a light emitting layer 133 is disposed between the anode electrode 131 and a cathode electrode 134 facing each other.

According to embodiments, the element layer 130 may include the anode electrodes 131 respectively disposed in the emission areas EA, a pixel defining layer 132 disposed in the non-emission area NEA and covering the edge portion of the anode electrode 131, a spacer layer 132' disposed on a part of the pixel defining layer 132, the light emitting layers 133 respectively disposed on the anode electrodes 131, and the cathode electrode 134 disposed on the light emitting layers 133, the pixel defining layer 132, and the spacer layer 132'.

In another example, each of the light emitting elements LE may further include first common layers 135 disposed between the anode electrodes 131 and the light emitting layers 133, and a second common layer 136 disposed between the light emitting layers 133 and the cathode electrode 134.

The encapsulation layer 140 may be disposed on the circuit layer 120 and cover the element layer 130.

The encapsulation layer 140 may block the permeation of oxygen or moisture into the element layer 130 and to reduce electrical or physical impact to the circuit layer 120 and the element layer 130.

The encapsulation layer 140 may include a first encapsulation layer 141 disposed on the circuit layer 120, covering the element layer 130, and including an inorganic insulating material, a second encapsulation layer 142 disposed on the first encapsulation layer 141, overlapping the element layer 130, and including an organic insulating material, and a third encapsulation layer 143 disposed on the first encapsulation layer 141, covering the second encapsulation layer 142, and including an inorganic insulating material.

The touch sensor layer 150 may be disposed on the encapsulation layer 140.

The polarization layer 160 may be disposed on the touch sensor layer 150.

As an example, the polarization layer 160 may be attached to the touch sensor layer 150 through an adhesive layer between the polarization layer 160 and a touch planarization layer 153.

FIG. 7 is a layout diagram showing a part A of FIG. 1 according to embodiments.

Referring to FIG. 7, the display panel 100 of the display device 10 according to embodiments may include the substrate 110 and the circuit layer 120 on the substrate 110.

The substrate 110 may include the main region MA and the sub-region SBA protruding from a side of the main region MA, and the main region MA may include the display area DA in which the emission areas EA (see FIG. 4) are arranged, and the non-display area NDA disposed around the display area DA.

As illustrated in FIGS. 4 and 5, the circuit layer 120 may include the light emitting pixel drivers EPD arranged side by side in the first direction DR1 and the second direction DR2 and electrically connected to the light emitting elements LE of the element layer 130, respectively.

As illustrated in FIG. 7, the circuit layer 120 may further include the first power lines VDL that are disposed in the display area DA, extend in the second direction DR2, and transmit the first power ELVDD (see FIG. 5) to the light emitting pixel drivers EPD.

The circuit layer 120 may further include the data lines DL that are disposed in the display area DA, extend in the second direction DR2, are adjacent to the first power lines VDL, and transmit the data signal Vdata (see FIG. 5).

According to embodiments, the circuit layer 120 may include a power sensing line VDTL that is disposed in the non-display area NDA and is electrically connected to one first power line VDL of the first power lines VDL, and a power sensing extension line VDTEXL that is electrically connected to the power sensing line VDTL and in contact with a side of the edge portion of the sub-region SBA.

The power sensing line VDTL may extend from the first side SD1, which faces the sub-region SBA and is adjacent to the sub-region SBA, among the edge portions of the display area DA to the sub-region SBA. For example, the power sensing line VDTL may be electrically connected to a portion of one first power line VDL adjacent to the first side SD1.

According to embodiments, the circuit layer 120 may further include the pads PD disposed in the sub-region SBA and connected to the circuit board 200.

The pads PD may be disposed in the second sub-region SB2. For example, the bending area BA of the sub-region SBA may be transformed into a bent shape, so that the circuit board 200 connected to the pads PD may be accommodated in the rear surface of the display panel 100.

The pads PD may include a power sensing transmission pad VDTPD electrically connected to the power sensing line VDTL.

The power sensing line VDTL may extend from the first side SD1 of the display area DA to the sub-region SBA and may be connected to a side of the power sensing transmission pad VDTPD.

The power sensing line VDTL may include a bypass portion BYP1 overlapping the dam area DMA (see FIG. 8), a first main portion MNP11 disposed between one first power line VDL and the bypass portion BYP1, and a second main portion MNP21 disposed between the power sensing transmission pad VDTPD and the bypass portion BYP1.

The power sensing extension line VDTEXL may extend from another side of the power sensing transmission pad VDTPD to a side of the edge portion of the sub-region SBA.

For example, the power sensing transmission pad VDTPD may be disposed and electrically connected between the power sensing line VDTL and the power sensing extension line VDTEXL.

According to embodiments, the circuit layer 120 may further include a power sensing additional line VDTAL disposed in the non-display area NDA and electrically connected to another first power line VDL of the first power lines VDL.

The power sensing additional line VDTAL may extend from the second side SD2 facing the first side SD1 among the edge portions of the display area DA to the sub-region SBA. For example, the power sensing additional line VDTAL may be electrically connected to a portion of another first power line VDL adjacent to the second side SD2.

The pads PD may further include a power sensing additional pad VDAPD electrically connected to the power sensing additional line VDTAL.

Similarly to the power sensing line VDTL, the power sensing additional line VDTAL may include a bypass portion BYP2 overlapping the dam area DMA (see FIG. 8), a first main portion MNP12 disposed between another first power line VDL and the bypass portion BYP2, and a second main portion MNP22 disposed between the power sensing additional pad VDAPD and the bypass portion BYP2.

According to embodiments, the voltage level at an end portion of one first power line VDL adjacent to the first side SD1 may be transmitted to the circuit board 200 through the power sensing line VDTL and the power sensing transmission pad VDTPD. Further, the voltage level at an end portion of another first power line VDL adjacent to the second side SD2 may be transmitted to the circuit board 200 through the power sensing additional line VDTAL and the power sensing additional pad VDAPD. Accordingly, it may be readily sensed whether the voltage level of the first power ELVDD supplied to the light emitting pixel drivers EPD through the first power lines VDL is normal. Accordingly, correction of the voltage level of the first power ELVDD may be facilitated, and the image quality of the display device 10 may be improved.

The power sensing additional line VDTAL may extend parallel to the third side SD3 from the second side SD2 spaced far from the sub-region SBA and may connect the power sensing additional pad VDAPD of the sub-region SBA.

For example, the power sensing line VDTL may be connected to a side of the power sensing transmission pad VDTPD of the sub-region SBA from the first side SD1 facing the sub-region SBA, and thus may extend to a short length as compared with the power sensing additional line VDTAL. As a result, the power sensing line VDTL may be more vulnerable to static electricity ESD than the power sensing additional line VDTAL.

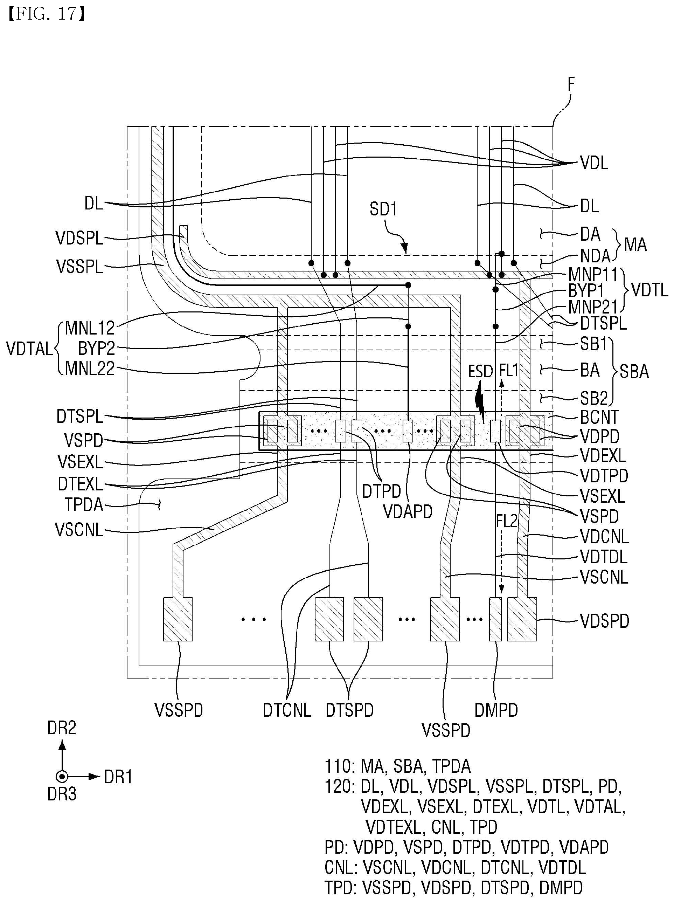

According to embodiments, as the circuit layer 120 includes the power sensing extension line VDTEXL extending from another side of the power sensing transmission pad VDTPD to a side of the edge portion of the sub-region SBA, during lighting inspection, the static electricity ESD (see FIG. 17) introduced through the pads PD may not only flow to the power sensing line VDTL, but also disperse into the power sensing extension line VDTEXL, so that the disconnection defect of the power sensing line VDTL due to the concentration of the static electricity ESD may be prevented.

According to embodiments, the circuit layer 120 may further include a first power supply line VDSPL that is disposed in the non-display area NDA, extends to the sub-region SBA, and transmits the first power ELVDD, and a first power extension line VDEXL that is electrically connected to the first power supply line VDSPL and in contact with a side of an edge portion of the sub-region SBA.

The pads PD may further include a first power pad VDPD electrically connected to the first power supply line VDSPL.

The first power pad VDPD may be disposed and electrically connected between the first power supply line VDSPL and the first power extension line VDEXL.

The circuit layer 120 may further include a second power supply line VSSPL that is disposed in the non-display area NDA, extends to the sub-region SBA, and transmits the second power ELVSS, and a second power extension line VSEXL that is electrically connected to the second power supply line VSSPL and in contact with a side of the edge portion of the sub-region SBA.

The pads PD may further include a second power pad VSPD electrically connected to the second power supply line VSSPL.

The second power pad VSPD may be disposed and electrically connected between the second power supply line VSSPL and the second power extension line VSEXL.

The pads PD may further include data pads DTPD transmitting the data signal Vdata of the data lines DL.

The circuit layer 120 may further include data supply lines DTSPL that are disposed in the non-display area NDA and sub-region SBA and electrically connect the data lines DL to the data pads DTPD, and data extension lines DTEXL that are electrically connected to the data supply lines DTSPL, extend from the data pads DTPD, and are in contact with a side of the edge portion of the sub-region SBA.

FIG. 8 is a plan view showing a part D of FIG. 7 according to an embodiment. FIG. 9 is a cross-sectional view taken along line E-E' of FIG. 8.

As illustrated in FIG. 8, according to an embodiment, the power sensing line VDTL may include the bypass portion BYP1 overlapping the dam area DMA, the first main portion MNP11 electrically connected to a side of the bypass portion BYP1, and the second main portion MNP21 electrically connected to another side of the bypass portion BYP1.

Referring to FIG. 9, the bypass portion BYP1 of the power sensing line VDTL may be disposed in at least one of the first gate conductive layer G1, G2, and G6 (see FIG. 6) on the first gate insulating layer 123, the second gate conductive layer CAE and LB2 (see FIG. 6) on the second gate insulating layer 124, or the third gate conductive layer G4 (see FIG. 6) on the third gate insulating layer 126.

Each of the first main portion MNP11 and the second main portion MNP21 of the power sensing line VDTL may be disposed in at least one of the first source-drain conductive layer ANCE1, VGIL, and DCE (see FIG. 6) on the second interlayer insulating layer 127, or the second source-drain conductive layer DL and ANCE2 (see FIG. 6) on the first planarization layer 128.

For example, as illustrated in FIG. 9, the bypass portion BYP1 of the power sensing line VDTL may be disposed on the third gate conductive layer on the third gate insulating layer 126.

The first main portion MNP11 of the power sensing line VDTL may include a first main line layer MNL11 that is disposed on the first source-drain conductive layer on the second interlayer insulating layer 127 and is electrically connected to a side of the bypass portion BYP1 through a bypass connection hole BYCH, and a second main line layer MNL21 that is disposed on the second source-drain conductive layer on the first planarization layer 128 and is electrically connected to the first main line layer MNL11.

For example, the second main portion MNP21 of the power sensing line VDTL may include the first main line layer MNL12 that is disposed on the first source-drain conductive layer on the second interlayer insulating layer 127 and is electrically connected to another side of the bypass portion BYP1 through the bypass connection hole BYCH, and the second main line layer MNL22 that is disposed on the second source-drain conductive layer on the first planarization layer 128 and is electrically connected to the first main line layer MNL12.

As illustrated in FIG. 8, according to an embodiment, the bypass portion BYP1 of the power sensing line VDTL may have a concave-convex shape including jig portions ZG whose extension direction is variable.

In each of the jig portions ZG, the extension direction of the bypass portion BYP1 may vary from the first direction DR1 to the second direction DR2 or may vary from the second direction DR2 to the first direction DR1.

For example, as the bypass portion BYP1 includes the jig portions ZG, the total extension length of the power sensing line VDTL may be made longer, so that the resistance of the power sensing line VDTL may be ensured to be a threshold or above for sensing the voltage level of the first power ELVDD.

According to embodiments, the first power supply line VDSPL, similarly to the power sensing line VDTL, may include a bypass portion BYP3 overlapping the dam area DMA, a first main portion MNP13 electrically connected to a side of the bypass portion BYP3, and a second main portion MNP23 electrically connected to another side of the bypass portion BYP3.

The first main portion MNP13 of the first power supply line VDSPL may be disposed adjacent to the first side SD1 of the edge portion of the display area DA, and may extend to the bypass portion BYP3 of the first power supply line VDSPL.

The second main portion MNP23 of the first power supply line VDSPL may extend from the bypass portion BYP3 of the first power supply line VDSPL to a first power supply pad VDSPD.

According to embodiments, the second power supply line VSSPL, similarly to the power sensing line VDTL, may include a bypass portion BYP4 overlapping the dam area DMA, a first main portion MNP14 electrically connected to a side of the bypass portion BYP4, and a second main portion MNP24 electrically connected to another side of the bypass portion BYP4.

The first main portion MNP14 of the second power supply line VSSPL may surround the periphery of the display area DA and extend to the bypass portion BYP4 of the second power supply line VSSPL.

The second main portion MNP24 of the second power supply line VSSPL may extend from the bypass portion BYP4 of the second power supply line VSSPL to a second power supply pad VSSPD.

Each of the bypass portion BYP3 of the first power supply line VDSPL and the bypass portion BYP4 of the second power supply line VSSPL may be disposed in at least one of the first gate conductive layer G1, G2, and G6 (see FIG. 6) on the first gate insulating layer 123, the second gate conductive layer CAE and LB2 (see FIG. 6) on the second gate insulating layer 124, or the third gate conductive layer G4 (see FIG. 6) on the third gate insulating layer 126.

Each of the first main portion MNP13 of the first power supply line VDSPL, the second main portion MNP23 of the first power supply line VDSPL, the first main portion MNP14 of the second power supply line VSSPL, and the second main portion MNP24 of the second power supply line VSSPL may be disposed in at least one of the first source-drain conductive layer ANCE1, VGIL, and DCE (see FIG. 6) on the second interlayer insulating layer 127 or the second source-drain conductive layer DL and ANCE2 (see FIG. 6) on the first planarization layer 128.

According to embodiments, the circuit layer 120 may further include a plurality of constant voltage supply lines CVSPL1, CVSPL2, and CVSPL3 disposed in the non-display area NDA and the sub-region SBA.

One of the plurality of constant voltage supply lines CVSPL1, CVSPL2, and CVSPL3 may transmit the gate initialization voltage VGINT (see FIG. 5).

Another one of the plurality of constant voltage supply lines CVSPL1, CVSPL2, and CVSPL3 may transmit the anode initialization voltage VAINT (see FIG. 5).

Yet another one of the plurality of constant voltage supply lines CVSPL1, CVSPL2, and CVSPL3 may transmit one of a gate high voltage and a gate low voltage. The gate high voltage and the gate low voltage may be provided for generating at least one of the scan write signal GW (see FIG. 5), the emission control signal EC, the gate control signal GC, or the bias control signal GB.

The first constant voltage supply line CVSPL1 among the plurality of constant voltage supply lines CVSPL1, CVSPL2, and CVSPL3, similarly to the power sensing line VDTL, may include a bypass portion BYP5 overlapping the dam area DMA, a first main portion MNP15 electrically connected to a side of the bypass portion BYP5, and a second main portion MNP25 electrically connected to another side of the bypass portion BYP5.

The second constant voltage supply line CVSPL2 among the plurality of constant voltage supply lines CVSPL1, CVSPL2, and CVSPL3, similarly to the power sensing line VDTL, may include a bypass portion BYP6 overlapping the dam area DMA, a first main portion MNP16 electrically connected to a side of the bypass portion BYP6, and a second main portion MNP26 electrically connected to another side of the bypass portion BYP6.

The third constant voltage supply line CVSPL3 among the plurality of constant voltage supply lines CVSPL1, CVSPL2, and CVSPL3, similarly to the power sensing line VDTL, may include a bypass portion BYP7 overlapping the dam area DMA, a first main portion MNP17 electrically connected to a side of the bypass portion BYP7, and a second main portion MNP27 electrically connected to another side of the bypass portion BYP7.

The bypass portions BYP5, BYP6, and BYP7 of the plurality of constant voltage supply lines CVSPL1, CVSPL2, and CVSPL3 may be disposed in at least one of the first gate conductive layer G1, G2, and G6 (see FIG. 6) on the first gate insulating layer 123, the second gate conductive layer CAE and LB2 (see FIG. 6) on the second gate insulating layer 124, or the third gate conductive layer G4 (see FIG. 6) on the third gate insulating layer 126.

Each of the first main portions MNP15, MNP16, and MNP17 and the second main portions MNP25, MNP26, and MNP27 of the plurality of constant voltage supply lines CVSPL1, CVSPL2, and CVSPL3 may be disposed in at least one of the first source-drain conductive layer ANCE1, VGIL, and DCE (see FIG. 6) on the second interlayer insulating layer 127, or the second source-drain conductive layer DL and ANCE2 (see FIG. 6) on the first planarization layer 128.

According to embodiments, in each of the first power supply line VDSPL, the second power supply line VSSPL, and the plurality of constant voltage supply lines CVSPL1, CVSPL2, and CVSPL3, protrusions PRO may be arranged side by side on the portion in the edge portion of the bypass portions BYP2, BYP3, BYP4, BYP5, BYP6, and BYP7 overlapping the dam area DMA, which does not overlap the first main portions MNP12, MNP13, MNP14, MNP15, MNP16, and MNP17 and the second main portions MNP22, MNP23, MNP24, MNP25, MNP26, and MNP27.

For example, the length of the gap between the bypass portions BYP2, BYP3, BYP4, BYP5, BYP6, and BYP7 provided in the first power supply line VDSPL, the second power supply line VSSPL, and the plurality of constant voltage supply lines CVSPL1, CVSPL2, and CVSPL3, and the inorganic insulating material may be made longer, so that the permeation of oxygen or moisture through the periphery of the bypass portions BYP2, BYP3, BYP4, BYP5, BYP6, and BYP7 may be delayed.

Accordingly, the lifespan of the display device 10 may be improved.

As illustrated in FIG. 9, according to embodiments, the first dam portion DM1 surrounding the display area DA, and the second dam portion DM2 surrounding the first dam portion DM1 may be arranged in the dam area DMA.

Each of the first dam portion DM1 and the second dam portion DM2 may include two or more dam layers DML11, DML21, DML31, and DML41 and DML12, DML22, and DML32.

Each of two or more dam layers DML11, DML21, DML31, and DML41 and DML12, DML22, and DML32 may be disposed on the same layer as one of the first planarization layer 128, the second planarization layer 129, the pixel defining layer 132, and the spacer layer 132'.

As an example, the first dam portion DM1 may include the first dam layer DML11, which is disposed on the same layer as the first planarization layer 128, the second dam layer DML21, which is disposed on the same layer as the second planarization layer 129, the third dam layer DML31, which is disposed on the same layer as the pixel defining layer 132, and the fourth dam layer DML41, which is disposed on the same layer as the spacer layer 132'.

For example, the second dam portion DM2 may include the first dam layer DML12, which is disposed on the same layer as the second planarization layer 129, the second dam layer DML22, which is disposed on the same layer as the pixel defining layer 132, and the third dam layer DML32, which is disposed on the same layer as the spacer layer 132'.

The second planarization layer 129 may cover the second source-drain conductive layer MNL21 and MNL22 on the first planarization layer 128 and may be spaced apart from at least one of the dam portion DM1 or DM2 of the dam area DMA.

The pixel defining layer 132 may be disposed on the second planarization layer 129.

Accordingly, in the dam area DMA, the second interlayer insulating layer 127 may be in contact with the first encapsulation layer 141 between the second planarization layer 129 and the first dam portion DM1, between the first dam portion DM1 and the second dam portion DM2, and between the second dam portion DM2 and the second planarization layer 129.

According to embodiments, the first encapsulation layer 141 of the encapsulation layer 140 may include an inorganic insulating material that covers the element layer 130.

The first encapsulation layer 141 may be disposed in the display area DA and may extend to the dam area DMA of the non-display area NDA.

The second encapsulation layer 142 may include an organic insulating material diffused in an area surrounded by at least one of the dam portion DM1 or DM2 disposed in the dam area DMA.

The third encapsulation layer 143 may include an inorganic insulating material covering the second encapsulation layer 142.

The third encapsulation layer 143 may extend to the dam area DMA of the non-display area NDA and may be in contact with the first encapsulation layer 141.

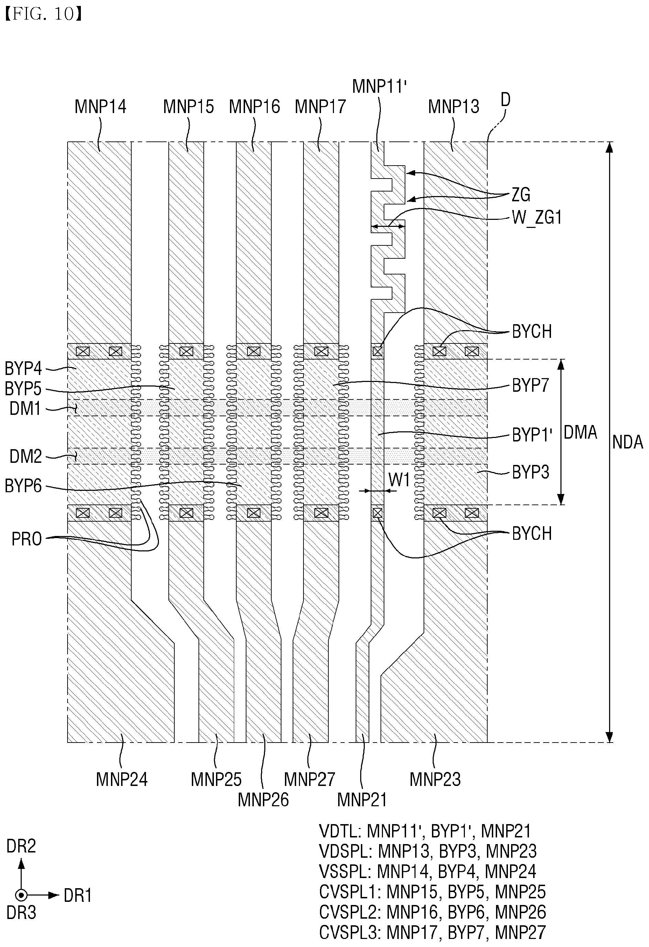

FIGS. 10, 11, and 12 are plan views illustrating a part D of FIG. 7 according to the respective embodiments.

The display device 10 according to the embodiment illustrated in FIG. 10 is substantially the same as the embodiment illustrated in FIGS. 7 to 9 except that a first main portion MNP11', not a bypass portion BYP1' that overlaps the dam area DMA in the power sensing line VDTL, disposed between one first power line VDL and the bypass portion BYP1' has a concave-convex shape including the jig portions ZG, and thus redundant descriptions will be omitted below.

According to the embodiment of FIG. 10, the bypass portion BYP1' of the power sensing line VDTL may be disposed in a straight line shape.

Considering that the bypass portion BYP1' of the power sensing line VDTL is disposed in at least one of the first gate conductive layer, the second gate conductive layer, or the third gate conductive layer and has a relatively high resistance, static electricity may be easy to be concentrated.

For example, as in the embodiment of FIG. 8, in the case that the bypass portion BYP1 of the power sensing line VDTL includes the jig portions ZG, overheating may occur due to the static electricity ESD (see FIG. 17) that is excessively concentrated in the jig portion ZG of the bypass portion BYP1, which results in bursting or disconnection defects of the bypass portion BYP1. For example, since interfacial lifting defects occur in the insulating layers around the point at which the bursting of the bypass portion BYP1 occurs, a permeation path for oxygen or moisture is generated, so that the lifespan of the display device 10 may be drastically reduced.

For example, according to the embodiment of FIG. 10, as the bypass portion BYP1' of the power sensing line VDTL is disposed in a straight line shape, excessive concentration does not occur although the static electricity ESD (see FIG. 17) is introduced into the bypass portion BYP1', so that bursting and disconnection defects due to overheating may be reduced. As a result, the lifespan of the display device 10 may be improved.

According to the embodiment of FIG. 10, instead of the bypass portion BYP1' of the power sensing line VDTL being disposed in a straight line shape, the first main portion MNP11' of the power sensing line VDTL may be disposed in a concave-convex shape including the jig portions ZG, so that the resistance of the power sensing line VDTL may be ensured to be a threshold or above for sensing the voltage level of the first power ELVDD.

According to the embodiment of FIG. 10, in the first direction DR1, the bypass portion BYP1' of the power sensing line VDTL may have a first width W1, and the jig portions ZG of the first main portion MNP11' of the power sensing line VDTL may have a first jig width W_ZG1.

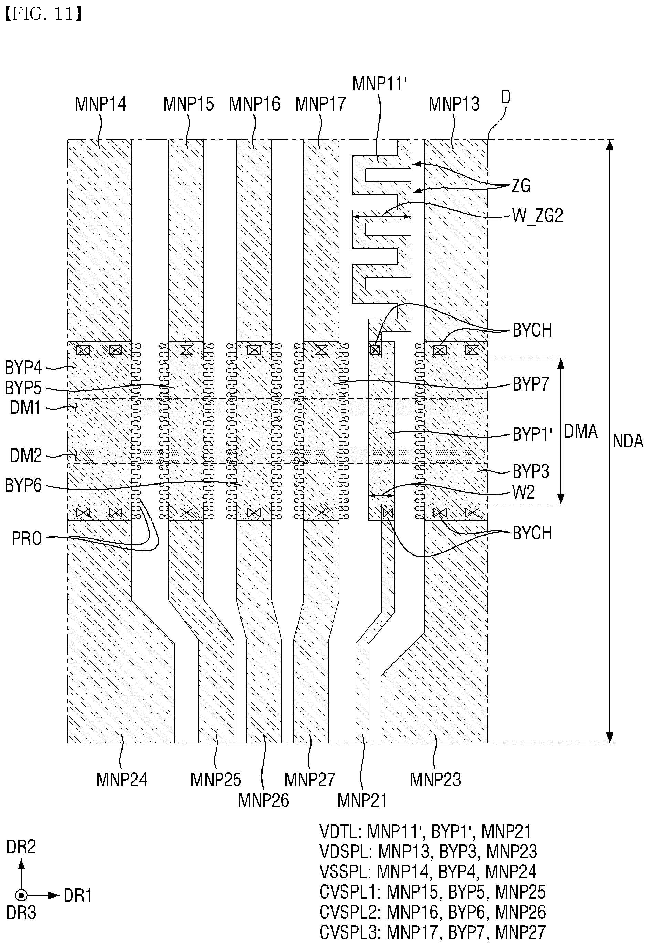

The display device 10 according to the embodiment illustrated in FIG. 11 is substantially the same as the embodiment of FIG. 10 except that in the first direction DR1, the bypass portion BYP1' of the power sensing line VDTL has a second width W2 that is larger than the first width W1 to have a lower resistance, and the jig portions ZG of the first main portion MNP11' of the power sensing line VDTL have a second jig width W_ZG2 that is larger than the first jig width W_ZG1, and thus redundant descriptions will be omitted below.

For example, the bypass portion BYP1' of the power sensing line VDTL may have a lower resistance, so that disconnection defects in the bypass portion BYP1' due to the static electricity ESD (see FIG. 17) may be further reduced.

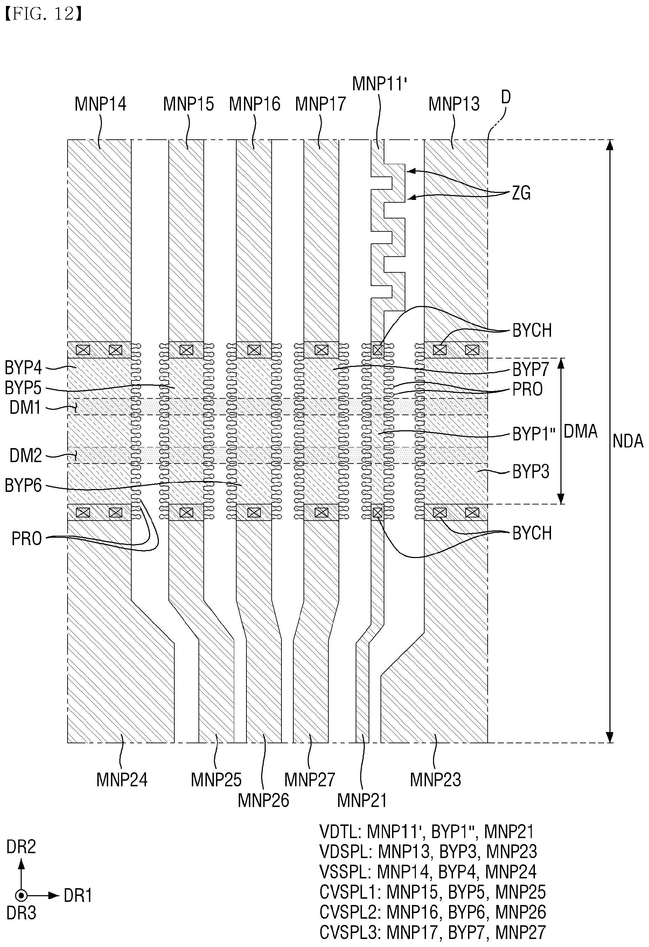

The display device 10 of the embodiment illustrated in FIG. 12 is substantially the same as the embodiments of FIGS. 10 and 11 except that the protrusions PRO are arranged side by side on the portion in the edge portion of a bypass portion BYP1'' of the power sensing line VDTL, which does not overlap the first main portion MNP11' and the second main portion MNP21, and thus redundant descriptions will be omitted below.

By doing this, the length of the gap between the bypass portion BYP1'' of the power sensing line VDTL and the inorganic insulating material may be made longer, so that the permeation of oxygen or moisture through the periphery of the bypass portion BYP1'' of the power sensing line VDTL may be delayed.

Accordingly, the lifespan of the display device 10 may be further improved.

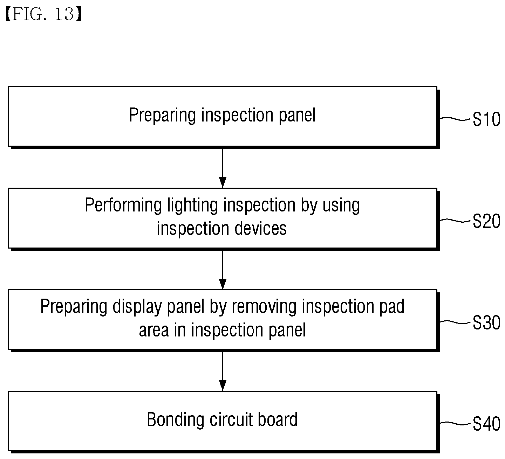

FIG. 13 is a flowchart illustrating a method of manufacturing the display device according to embodiments.

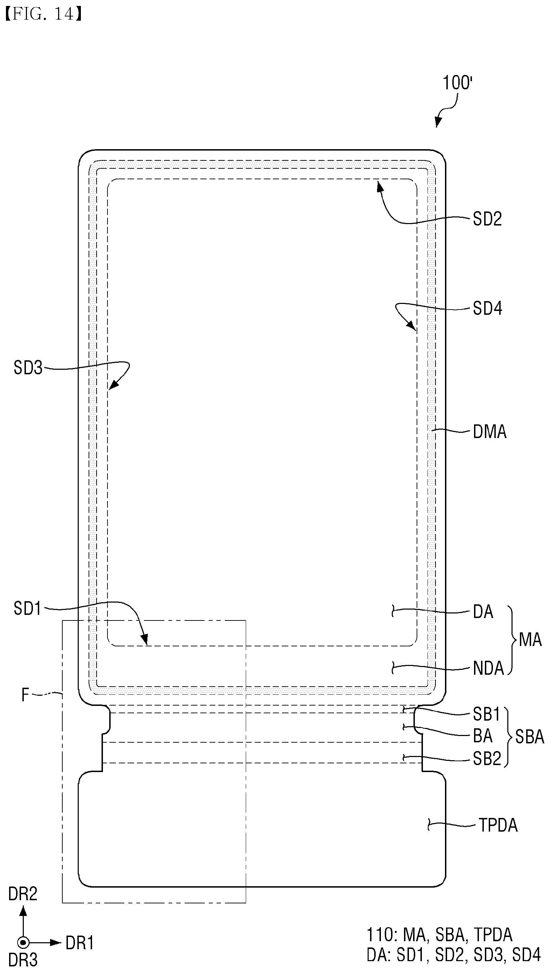

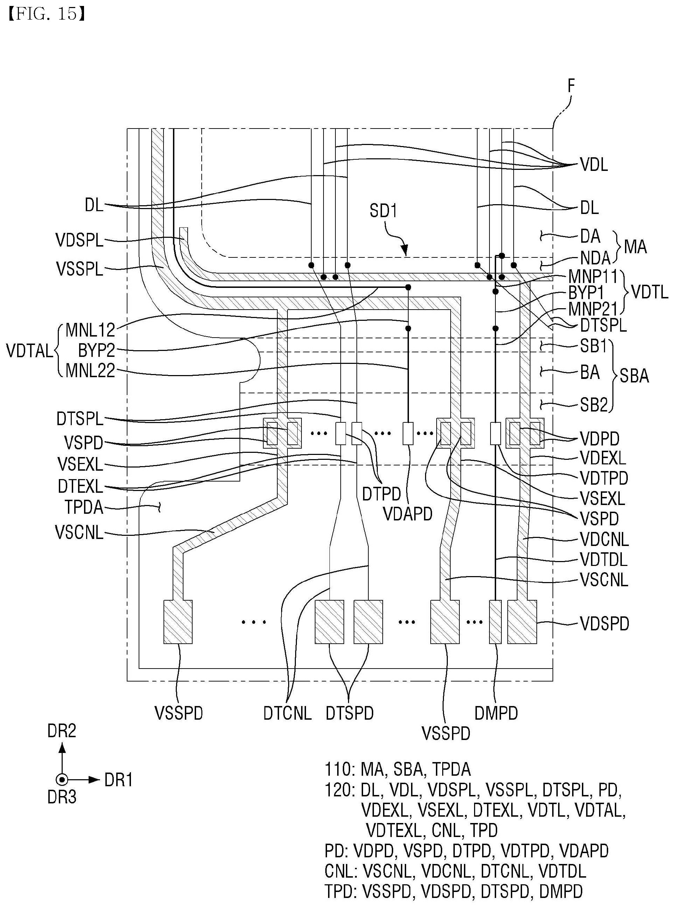

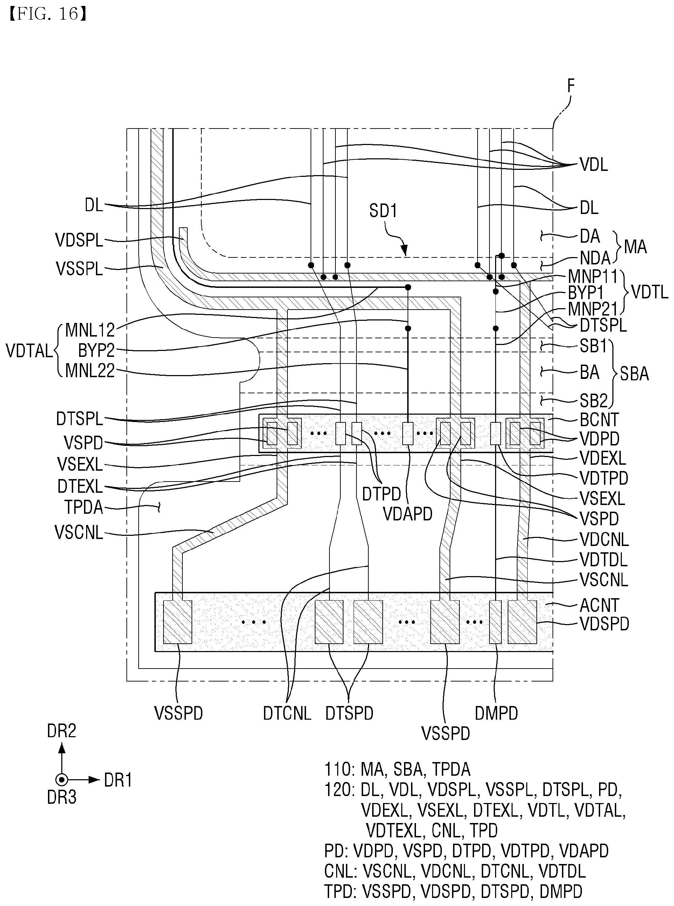

Referring to FIG. 13, the method of manufacturing the display device 10 according to embodiments may include preparing an inspection panel 100' (see FIG. 14) (step S10), performing a lighting inspection on the inspection panel 100' by using first and second connectors ACNT and BCNT (see FIG. 16) of inspection devices connected to inspection connection pads TPD (see FIG. 15) of an inspection pad area TPDA (see FIG. 14) in the inspection panel 100' (step S20), preparing the display panel 100 by removing the inspection pad area TPDA in the inspection panel 100' (step S30), and bonding the circuit board 200 to the pads PD of the sub-region SBA in the display panel 100 (step S40).

FIG. 14 is a plan view illustrating the inspection panel during the step of preparing the inspection panel of FIG. 13 according to embodiments. FIG. 15 is a layout diagram showing a part F of FIG. 14 according to an embodiment. FIGS. 16 and 17 are process diagrams illustrating steps of performing the lighting inspection of FIG. 13 according to an embodiment.

Referring to FIG. 14, in the step S10 of preparing the inspection panel 100' (see FIG. 14), the display device 10 according to embodiments may include the inspection panel 100', and the inspection panel 100' may include the substrate 110, the circuit layer 120, and the element layer 130.

The substrate 110 of the inspection panel 100' not only may include the main region MA and the sub-region SBA, but also may further include the inspection pad area TPDA connected to a side of the edge portion of the sub-region SBA.

Referring to FIG. 15, the circuit layer 120 of the inspection panel 100' may further include the inspection connection pads TPD disposed in the inspection pad area TPDA, and inspection connection lines CNL disposed in the inspection pad area TPDA and extending from a side of the edge portion of the sub-region SBA.

At least some of the inspection connection lines CNL may be connected to the inspection connection pads TPD.

A connector ACNT (see FIG. 16) of an inspection device that supplies inspection signals for lighting inspection may be connected to the inspection connection pads TPD.

The inspection connection lines CNL may include a power sensing dummy line VDTDL connected to the power sensing extension line VDTEXL.

The inspection connection pads TPD may include a dummy pad DMPD that is electrically connected to the power sensing dummy line VDTDL.

According to an embodiment, the inspection connection lines CNL may further include a first power connection line VDCNL connected to the first power extension line VDEXL, a second power connection line VSCNL connected to the second power extension line VSEXL, and data connection lines DTCNL connected to the data extension lines DTEXL.

For example, the inspection connection pads TPD may further include the first power supply pad VDSPD electrically connected to the first power connection line VDCNL, the second power supply pad VSSPD electrically connected to the second power connection line VSCNL, and inspection data supply pads DTSPD electrically connected to the data connection lines DTCNL.

The first power connection line VDCNL may be connected to the first power extension line VDEXL at the boundary between the sub-region SBA and the inspection pad area TPDA and may extend to the first power supply pad VDSPD.

The second power connection line VSCNL may be connected to the second power extension line VSEXL at the boundary between the sub-region SBA and the inspection pad area TPDA and may extend to the second power supply pad VSSPD.

The data connection lines DTCNL may be connected to the data extension lines DTEXL at the boundary between the sub-region SBA and the inspection pad area TPDA, and may extend to the inspection data supply pads DTSPD.

According to embodiments, the power sensing line VDTL may be for sensing the voltage level of the first power ELVDD applied to the first side SD1 of the display area DA, and the power sensing additional line VDTAL may be provided in the circuit layer 120 to sense the voltage level of the first power ELVDD applied to the second side SD2 of the display area DA. Accordingly, the inspection device for lighting inspection may not need to be electrically connected to the power sensing line VDTL and the power sensing additional line VDTAL.

According to embodiments, unlike the power sensing additional line VDTAL disposed in a relatively long path between the second side SD2 and the sub-region SBA, the power sensing line VDTL may be disposed in a relatively short path between the first side SD1 and the sub-region SBA. However, the power sensing line VDTL may have a relatively thin width as it is intended to transmit signals rather than power, and, similarly to the power sensing additional line VDTAL, may be vulnerable to disconnection defects due to the static electricity ESD as it includes the jig portions ZG to have a resistance of a threshold or above to sense the voltage level of the first power ELVDD.

According to embodiments, in order to prevent the static electricity ESD from concentrating on the power sensing line VDTL, the circuit layer 120 may include the power sensing extension line VDTEXL, the power sensing dummy line VDTDL, and the dummy pad DMPD electrically connected to the power sensing line VDTL and the power sensing transmission pad VDTPD. For example, the static electricity ESD introduced into the power sensing transmission pad VDTPD may be discharged to the power sensing extension line VDTEXL, the power sensing dummy line VDTDL, and the dummy pad DMPD.

Referring to FIG. 16, in the step S20 of performing the lighting inspection, the A connector ACNT of the inspection device may be connected to the inspection connection pads TPD of the inspection pad area TPDA, and the B connector BCNT of the inspection device may be connected to the pads PD of the second sub-region SB2.

Accordingly, various inspection signals of the inspection device for lighting inspection may be applied to the inspection connection pads TPD connected to the A connector ACNT and the pads PD connected to the B connector BCNT.

However, as illustrated in FIG. 17, in a state where the B connector BCNT of the inspection device is connected to the pads PD of the second sub-region SB2, the static electricity ESD may be introduced into the pads PD.

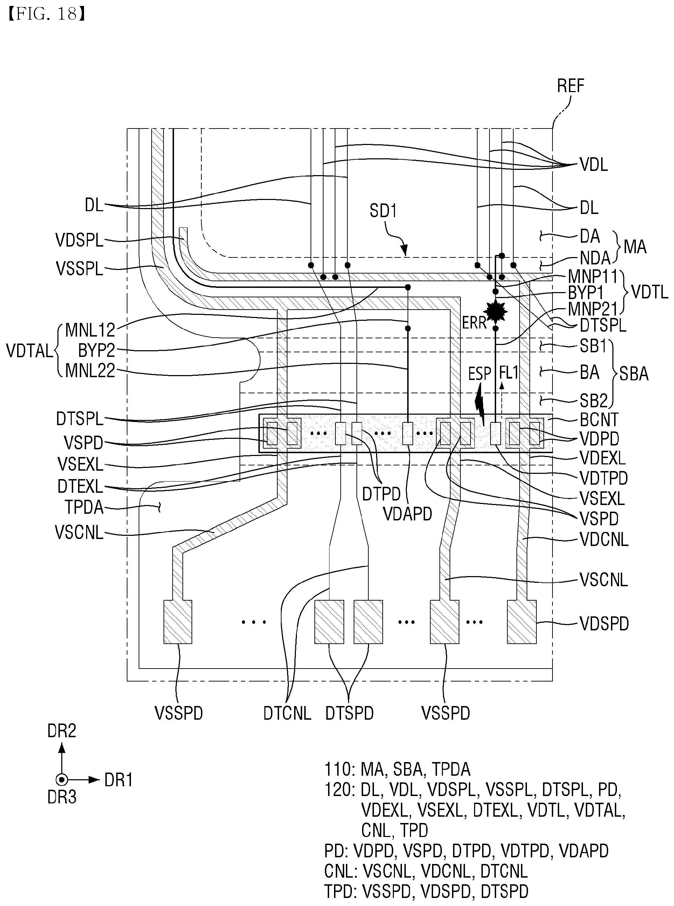

FIG. 18 is a process diagram illustrating steps of performing the lighting inspection of FIG. 13 according to a comparative example.

As in a comparative example REF illustrated in FIG. 18, in the case that the power sensing transmission pad VDTPD is connected only to the power sensing line VDTL, the static electricity ESD introduced around the power sensing transmission pad VDTPD may be concentrated on the power sensing line VDTL through a first electrostatic path FL1. At this time, as the bypass portion BYP1 of the power sensing line VDTL is disposed in at least one of the first gate conductive layer, the second gate conductive layer, or the third gate conductive layer and has a relatively high resistance, the static electricity ESD of the first electrostatic path FL1 may be concentrated on the bypass portion BYP1 of the power sensing line VDTL, so that the bypass portion BYP1 of the power sensing line VDTL may overheat, and as a result, a disconnection defect ERR of the power sensing line VDTL may occur.

For example, as illustrated in FIG. 17, according to an embodiment, the power sensing extension line VDTEXL, the power sensing dummy line VDTDL, and the dummy pad DMPD electrically connected to the power sensing line VDTL and the power sensing transmission pad VDTPD are included. Accordingly, the static electricity ESD introduced around the power sensing transmission pad VDTPD may be transmitted to the power sensing line VDTL through the first electrostatic path FL1, and may be dispersed into the power sensing extension line VDTEXL, the power sensing dummy line VDTDL, and the dummy pad DMPD through a second electrostatic path FL2.

Accordingly, since the amount of the static electricity ESD introduced into the power sensing line VDTL through the first electrostatic path FL1 may be reduced, the disconnection defect of the power sensing line VDTL due to the static electricity ESD may be reduced.

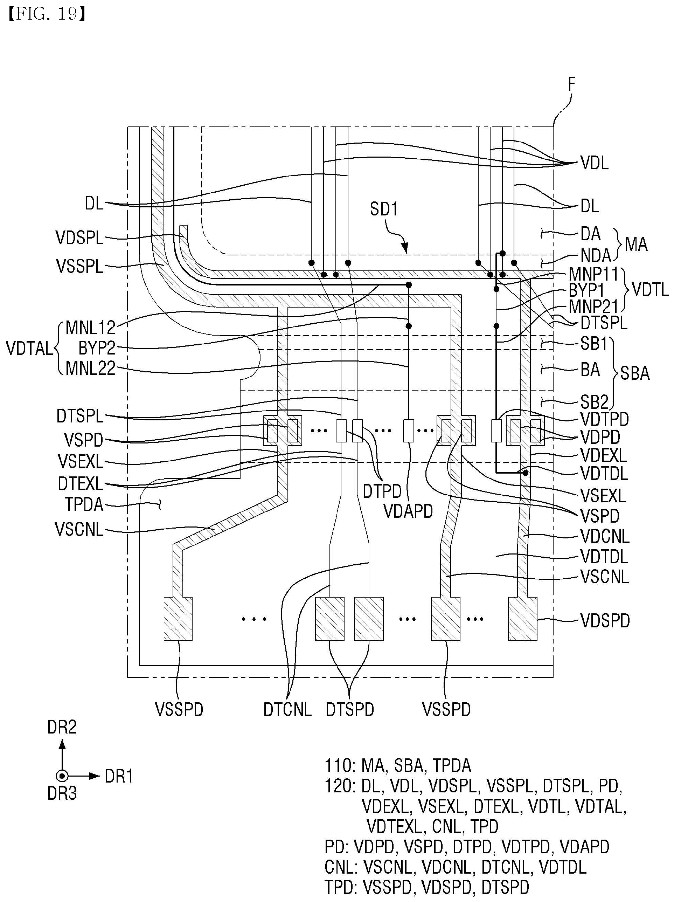

FIG. 19 is a layout diagram showing a part F of FIG. 14 according to another embodiment.

The display device 10 of the embodiment illustrated in FIG. 19 is substantially the same as the embodiment illustrated in FIGS. 15, 16, and 17 except that the inspection panel 100' does not include the dummy pad DMPD, and the power sensing dummy line VDTDL is electrically connected to the first power connection line VDCNL, and thus redundant descriptions will be omitted below.

For example, even without providing the dummy pad DMPD, the static electricity ESD introduced around the power sensing transmission pad VDTPD may be dispersed to the side of the power sensing extension line VDTEXL, the power sensing dummy line VDTDL, the first power connection line VDCNL, and the first power supply pad VDSPD.

Accordingly, since the dummy pad DMPD that does not need to be connected to the inspection device may be removed, the structure of the inspection panel 100' may be simplified.

Subsequently, as illustrated in FIG. 7, the display panel 100 may be prepared by removing the inspection pad area TPDA from the inspection panel 100' (step S30).

For example, as illustrated in FIG. 1, the display device 10 may be prepared by bonding the circuit board 200 to the display panel 100 (step S40).

Although the embodiments of the present invention have been described with reference to the accompanying drawings, it will be understood by those skilled in the art that the present invention may be implemented in other specific forms without departing from the spirit or essential characteristics thereof. Therefore, it should be understood that the embodiments described above are illustrative in all respects and not restrictive.

## Claims

1. A display device comprising:
a display panel; and
a circuit board bonded to the display panel, wherein
the display panel comprises:
a substrate;
a circuit layer disposed on the substrate; and
an element layer disposed on the circuit layer,
the substrate comprises a main region and a sub-region protruding from a side of the main region,
the main region comprises:
a display area in which emission areas are arranged, and
a non-display area disposed around the display area,
the element layer comprises light emitting elements respectively disposed in the emission areas, and
the circuit layer comprises:
light emitting pixel drivers arranged side by side with each other in a first direction and a second direction and electrically connected to the light emitting elements, respectively;
first power lines disposed in the display area, extending in the second direction, and transmitting a first power to the light emitting pixel drivers;
a power sensing line disposed in the non-display area, extending from a first side of an edge portion of the display area, which faces the sub-region and adjacent to the sub-region, to the sub-region, and electrically connected to one first power line of the first power lines; and
a power sensing extension line electrically connected to the power sensing line and in contact with a side of an edge portion of the sub-region.

2. The display device of claim 1, wherein
the circuit layer further comprises pads disposed in the sub-region and connected to the circuit board,
the pads comprise a power sensing transmission pad electrically connected to the power sensing line,
the power sensing line is connected to a side of the power sensing transmission pad, and the power sensing extension line extends from another side of the power sensing transmission pad to the side of the edge portion of the sub-region.

3. The display device of claim 2, wherein
the circuit layer further comprises a power sensing additional line disposed in the non-display area, extending from a second side of the edge portion of the display area, which is opposite the first side of the edge portion of the display area, to the sub-region, and electrically connected to another first power line of the first power lines, and
the pads further comprise a power sensing additional pad electrically connected to the power sensing additional line.

4. The display device of claim 2, further comprising:
an encapsulation layer disposed on the element layer; and
at least one dam portion disposed in a dam area of the non-display area surrounding the display area, wherein
the circuit layer further comprises:
a first gate insulating layer disposed on the substrate;
a first gate conductive layer disposed on the first gate insulating layer;
a second gate insulating layer covering the first gate conductive layer;
a second gate conductive layer disposed on the second gate insulating layer;
a first interlayer insulating layer covering the second gate conductive layer;
a third gate insulating layer disposed on the first interlayer insulating layer;
a third gate conductive layer disposed on the third gate insulating layer;
a second interlayer insulating layer covering the third gate conductive layer;
a first source-drain conductive layer disposed on the second interlayer insulating layer;
a first planarization layer covering the first source-drain conductive layer;
a second source-drain conductive layer disposed on the first planarization layer; and
a second planarization layer covering the second source-drain conductive layer,
a bypass portion of the power sensing line overlapping the dam area is disposed on one of the first gate conductive layer, the second gate conductive layer, and the third gate conductive layer,
a first main portion of the power sensing line disposed between the bypass portion and the one first power line is disposed on at least one of the first source-drain conductive layer or the second source-drain conductive layer, and
a second main portion of the power sensing line disposed between the bypass portion and the power sensing transmission pad is disposed on at least one of the first source-drain conductive layer or the second source-drain conductive layer.

5. The display device of claim 4, wherein the bypass portion has a form comprising jig portions whose extension direction is variable.

6. The display device of claim 4, wherein a part of the first main portion of the power sensing line adjacent to the bypass portion has a form comprising jig portions whose extension direction is variable.

7. The display device of claim 6, wherein a total extension length of the jig portions corresponds to a width of the bypass portion.

8. The display device of claim 4, wherein the encapsulation layer comprises:
a first encapsulation layer disposed on the element layer;
a second encapsulation layer disposed on the first encapsulation layer; and
a third encapsulation layer disposed on the first encapsulation layer and covering the second encapsulation layer,
each of the first encapsulation layer and the third encapsulation layer includes an inorganic insulating material,
the second encapsulation layer includes an organic insulating material disposed in an area surrounded by the at least one dam portion, and
the third encapsulation layer is in contact with the first encapsulation layer at an outside of the dam area.

9. The display device of claim 2, wherein
the substrate further comprises an inspection pad area connected to a side of the edge portion of the sub-region, and
the circuit layer further comprises:
inspection connection pads disposed in the inspection pad area and connected to a connector of an inspection device that supplies inspection signals for lighting inspection; and
inspection connection lines disposed in the inspection pad area and extending from the side of the edge portion of the sub-region, and
the inspection connection lines comprise a power sensing dummy line connected to the power sensing extension line.

10. The display device of claim 9, wherein the inspection connection pads comprise a dummy pad electrically connected to the power sensing dummy line.

11. The display device of claim 9, wherein
the circuit layer further comprises:
a first power supply line disposed in the non-display area and transmitting the first power; and
a first power extension line electrically connected to the first power supply line and in contact with the side of the edge portion of the sub-region,
the inspection connection lines further comprise a first power connection line connected to the first power extension line,
the inspection connection pads further comprise a first power supply pad electrically connected to the first power connection line, and
the power sensing dummy line is electrically connected to the first power connection line.

12. A method of manufacturing a display device, the method comprising:
preparing an inspection panel;
performing a lighting inspection on the inspection panel by using an inspection device connected to inspection connection pads of an inspection pad area in the inspection panel;
preparing a display panel by removing the inspection pad area in the inspection panel; and
bonding a circuit board to pads of a sub-region in the display panel, wherein
in the preparing of the inspection panel, the display panel comprises:
a substrate;
a circuit layer disposed on the substrate; and
an element layer disposed on the circuit layer,
the substrate comprises:
a main region comprising a display area in which emission areas are arranged, and a non-display area disposed around the display area; and
a sub-region protruding from a side of the main region and having a side connected to the inspection pad area,
the element layer comprises light emitting elements respectively disposed in the emission areas, and
the circuit layer comprises:
light emitting pixel drivers arranged side by side with each other in a first direction and a second direction and electrically connected to the light emitting elements, respectively;
first power lines disposed in the display area, extending in the second direction, and transmitting a first power to the light emitting pixel drivers;
a power sensing line disposed in the non-display area, extending from a first side of an edge portion of the display area facing the sub-region and adjacent to the sub-region to the sub-region, and electrically connected to one first power line of the first power lines;
a power sensing extension line electrically connected to the power sensing line and in contact with a side of an edge portion of the sub-region;
inspection connection pads disposed in the inspection pad area; and
inspection connection lines disposed in the inspection pad area and extending from the side of the edge portion of the sub-region, and
the inspection connection lines comprise a power sensing dummy line electrically connected to the power sensing extension line.

13. The method of claim 12, wherein in the preparing of the inspection panel,
the circuit layer further comprises pads disposed in the sub-region and connected to the circuit board,
the pads comprise a power sensing transmission pad electrically connected to the power sensing line,
the power sensing line is connected to a side of the power sensing transmission pad, and
the power sensing extension line extends from another side of the power sensing transmission pad to the side of the edge portion of the sub-region.

14. The method of claim 13, wherein the inspection connection pads comprise a dummy pad electrically connected to the power sensing dummy line.

15. The method of claim 13, wherein
in the preparing of the inspection panel, the circuit layer further comprises:
a first power supply line disposed in the non-display area and transmitting the first power; and
a first power extension line electrically connected to the first power supply line and in contact with a side of the edge portion of the sub-region,
the inspection connection lines further comprise a first power connection line connected to the first power extension line, and
the inspection connection pads further comprise a first power supply pad electrically connected to the first power connection line.

16. The method of claim 15, wherein the power sensing dummy line is electrically connected to the first power connection line.

17. The method of claim 13, wherein in the preparing of the inspection panel,
the circuit layer further comprises a power sensing additional line disposed in the non-display area, extending from a second side of the edge portion of the display area, which is opposite the first side of the edge portion of the display area, to the sub-region, and electrically connected to another first power line of the first power lines, and
the pads further comprise a power sensing additional pad electrically connected to the power sensing additional line.

18. The method of claim 13, wherein
in the preparing of the inspection panel, the inspection panel further comprises at least one dam portion disposed in a dam area of the non-display area surrounding the display area,
the circuit layer further comprises:
a first gate insulating layer disposed on the substrate;
a first gate conductive layer disposed on the first gate insulating layer;
a second gate insulating layer covering the first gate conductive layer;
a second gate conductive layer disposed on the second gate insulating layer;
a first interlayer insulating layer covering the second gate conductive layer;
a third gate insulating layer disposed on the first interlayer insulating layer;
a third gate conductive layer disposed on the third gate insulating layer;
a second interlayer insulating layer covering the third gate conductive layer;
a first source-drain conductive layer disposed on the second interlayer insulating layer;
a first planarization layer covering the first source-drain conductive layer;
a second source-drain conductive layer disposed on the first planarization layer; and
a second planarization layer covering the second source-drain conductive layer,
a bypass portion of the power sensing line overlapping the dam area is disposed on one of the first gate conductive layer, the second gate conductive layer, and the third gate conductive layer,
a first main portion of the power sensing line disposed between the bypass portion and the one first power line is disposed on at least one of the first source-drain conductive layer or the second source-drain conductive layer, and
a second main portion of the power sensing line disposed between the bypass portion and the power sensing transmission pad is disposed on at least one of the first source-drain conductive layer or the second source-drain conductive layer.

19. The method of claim 18, wherein the bypass portion has a form comprising jig portions whose extension direction is variable.

20. The method of claim 18, wherein a part of the first main portion of the power sensing line adjacent to the bypass portion has a form comprising jig portions whose extension direction is variable.
